# EUROPEAN PATENT APPLICATION

(11) **EP 4 749 935 A1**
(43) Date of publication of application: **27.05.2026**
(21) Application number: 24856684.6
(22) Date of filing: 30.07.2024
(51) Int. Cl.: H04B 1/40, H02J 7/00, H03F 1/02, H03F 3/195, H04B 1/04

(54) **ELECTRONIC DEVICE AND METHOD FOR SUPPLYING VOLTAGE TO CONTROL CIRCUIT OF FRONT END MODULE**

(30) Priority: 23.08.2023 KR 20230110914; 22.09.2023 KR 20230127478
(71) Applicant: Samsung Electronics Co., Ltd., Suwon-si, Gyeonggi-do 16677 (KR)
(72) Inventor: LEE, Youngmin, Suwon-si Gyeonggi-do 16677 (KR); NA, Hyoseok, Suwon-si Gyeonggi-do 16677 (KR); MOON, Yohan, Suwon-si Gyeonggi-do 16677 (KR)
(74) Representative: Arnold & Siedsma
(86) International application number: PCT/KR2024/011130
(87) International publication number: WO 2025/042071

(57) **Abstract**

According to embodiments, an electronic device is provided. The electronic device may include: a processor; a radio frequency (RF) transceiver; a radio frequency front end (RFFE) module connected to the RF transceiver; an antenna connected to the RFFE module; a battery configured to provide a first voltage; and a power supply circuit configured to supply a second voltage for a power amplifier (PA) on the basis of the first voltage. The RFFE module may include a control circuit for controlling the PA bias in the RFFE module and at least one switch in the RFFE module, and a switching circuit for the control circuit.

## Description

### [Technical Field]

The following descriptions relate to an electronic device and a method for supplying a voltage to a control circuit of a front end module.

### [Background Art]

An electronic device may include radio frequency front end modules (RFFE) to transmit or receive a signal. For example, an RFFE module may include a power amplifier (PA) for a transmit power of a signal to be transmitted through an antenna connected to the RFFE module. The RFFE module may include a control circuit for supplying a bias voltage to the power amplifier and operating at least one switch within the RFFE module.

The above-described information may be provided as a related art for the purpose of helping understanding of the present disclosure. No argument or decision is made as to whether any of the above description may be applied as a prior art related to the present disclosure.

### [Disclosure]

### [Technical Solution]

In embodiments, an electronic device is provided. The electronic device may comprise a processor, a radio frequency (RF) transceiver, a radio frequency front end (RFFE) module connected to the RF transceiver, an antenna connected to the RFFE module, a battery configured to provide a first voltage, and a power supply circuit configured to supply a second voltage for a power amplifier (PA) based on the first voltage. The RFFE module may include a control circuit for controlling a PA bias within the RFFE module and at least one switch within the RFFE module and a switching circuit for the control circuit. The processor may be configured to control the switching circuit to supply, to the control circuit, the first voltage between the first voltage and the second voltage based on the first voltage being higher than or equal to a voltage threshold. The processor may be configured to control the switching circuit to supply, to the control circuit, the second voltage between the first voltage and the second voltage based on the first voltage being lower than the voltage threshold.

In embodiments, a radio frequency front end (RFFE) module is provided. The RFFE module may comprise a power amplifier (PA), a control circuit for controlling a PA bias to the PA and at least one switch within the RFFE module, and a switching circuit for the control circuit. The RFFE module may be configured to obtain a first voltage of a battery and obtain a second voltage of a power supply circuit. The switching circuit may be configured to selectively supply the first voltage of the battery or the second voltage of the power supply circuit to the control circuit. The control circuit may include at least one of a PA bias circuit for supplying a bias voltage for the PA, a logic circuit for controlling the at least one switch, or a supply circuit for supplying a power to the at least one switch.

In embodiments, an electronic device is provided. The electronic device 101 may comprise a processor, a radio frequency (RF) transceiver, a radio frequency front end (RFFE) module connected to the RF transceiver, an antenna connected to the RFFE module, a battery configured to provide a first voltage, and a power supply circuit configured to supply a second voltage for a power amplifier (PA) based on the first voltage. The RFFE module may include a control circuit for controlling a PA bias within the RFFE module and at least one switch within the RFFE module and a switching circuit for the control circuit. The switching circuit may be controlled, in accordance with control of the processor or the RF transceiver, to supply, to the control circuit, the first voltage between the first voltage and the second voltage based on the first voltage being higher than or equal to a voltage threshold, and to supply, to the control circuit, the second voltage between the first voltage and the second voltage based on the first voltage being lower than the voltage threshold.

### [Description of the Drawings]

FIG. 1 is a block diagram of an electronic device in a network environment.
FIG. 2 represents an example of an electronic device including a radio frequency end (RFFE) module.
FIG. 3A represents an example of a control circuit of an RFFE module.
FIG. 3B represents a relationship between a control circuit of an RFFE module and performance of a power amplifier.
FIGS. 4A, 4B, and 4C represent an example of an RFFE module including a control circuit and a switching circuit for providing the control circuit with a voltage.
FIGS. 5A, 5B, and 5C represent an example of an electronic device including an RFFE module connected to an inductor.
FIG. 6 represents an example of an electronic device including a plurality of RFFE modules and a plurality of power supply circuits.
FIG. 7 represents an example of an electronic device for supplying a supply voltage of a power amplifier to each RFFE module.
FIG. 8 represents an example of an electronic device for supplying a supply voltage of a power amplifier to each RFFE module.
FIG. 9 represents an operation flow of an electronic device for supplying a voltage to a control circuit of an RFFE module.

### [Mode for Invention]

Terms used in the present disclosure are used only to describe a specific embodiment, and may not be intended to limit a range of another embodiment. A singular expression may include a plural expression unless the context clearly means otherwise. Terms used herein, including a technical or a scientific term, may have the same meaning as those generally understood by a person with ordinary skill in the art described in the present disclosure. Among the terms used in the present disclosure, terms defined in a general dictionary may be interpreted as identical or similar meaning to the contextual meaning of the relevant technology and are not interpreted as ideal or excessively formal meaning unless explicitly defined in the present disclosure. In some cases, even terms defined in the present disclosure may not be interpreted to exclude embodiments of the present disclosure.

In various embodiments of the present disclosure described below, a hardware approach will be described as an example. However, since the various embodiments of the present disclosure include technology that uses both hardware and software, the various embodiments of the present disclosure do not exclude a software-based approach.

A term referring to a component of an electronic device (e.g., a communication module, a wireless communication module, a substrate, a printed circuit board (PCB), a flexible PCB (FPCB), a module, an antenna, an antenna element, a circuit, a processor, a chip, a component, or a device), a term referring to an RF-related component (a front end module (FEM), a power amplifier module (PAM), a FEM including duplexer (FEMid), a power amplifier module including duplexer (LPAMid), a Low noise amplifier PAM including duplexer (LPAMid), a radio frequency front end (RFFE), or a radio frequency integrated circuit (RFIC)), a term referring to a shape of a component (e.g., a structure, a construction, a support, a contact, or a protrusion), a term referring to a connection between structures (e.g., a connection, a contact, a support, a contact structure, a conductive member, or an assembly), a term referring to a circuit (e.g., a PCB, an FPCB, a signal line, and a feeding line, a data line, an RF signal line, an antenna line, a signal path, an RF path, an RF module, an RF circuit, a splitter, a divider, a coupler, or a combiner), and the like used in the following description are exemplified for convenience of description. Therefore, the present disclosure is not limited to terms to be described below, and another term having an equivalent technical meaning may be used. In addition, a term such as '...unit', '...device', '...object', and '...structure', and the like used below may mean at least one shape structure or may mean a unit processing a function.

In addition, in the present disclosure, the term 'greater than' or 'less than' may be used to determine whether a particular condition is satisfied or fulfilled, but this is only a description to express an example and does not exclude description of 'greater than or equal to' or 'less than or equal to'. A condition described as 'greater than or equal to ' may be replaced with 'greater than', a condition described as 'less than or equal to' may be replaced with 'less than', and a condition described as ' greater than or equal to and less than' may be replaced with 'greater than and less than or equal to'. In addition, hereinafter, 'A' to 'B' refers to at least one of elements from A (including A) to B (including B). Hereinafter, 'C' and/or 'D' means including at least one of 'C' or 'D', that is, {'C', 'D', and 'C' and 'D'}.

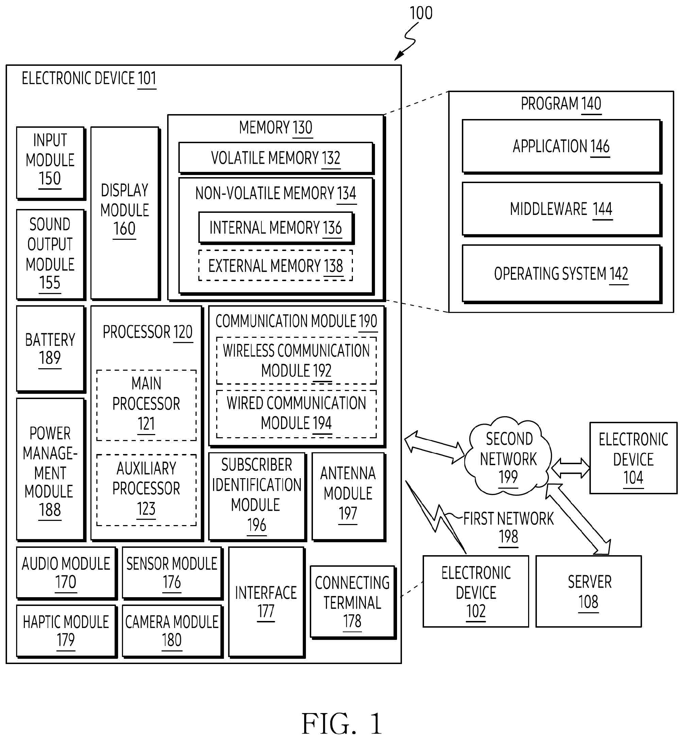

FIG. 1 is a block diagram illustrating an electronic device 101 in a network environment 100 according to various embodiments.

Referring to FIG. 1, the electronic device 101 in the network environment 100 may communicate with an electronic device 102 via a first network 198 (e.g., a short-range wireless communication network), or at least one of an electronic device 104 or a server 108 via a second network 199 (e.g., a long-range wireless communication network). According to an embodiment, the electronic device 101 may communicate with the electronic device 104 via the server 108. According to an embodiment, the electronic device 101 may include a processor 120, memory 130, an input module 150, a sound output module 155, a display module 160, an audio module 170, a sensor module 176, an interface 177, a connecting terminal 178, a haptic module 179, a camera module 180, a power management module 188, a battery 189, a communication module 190, a subscriber identification module(SIM) 196, or an antenna module 197. In some embodiments, at least one of the components (e.g., the connecting terminal 178) may be omitted from the electronic device 101, or one or more other components may be added in the electronic device 101. In some embodiments, some of the components (e.g., the sensor module 176, the camera module 180, or the antenna module 197) may be implemented as a single component (e.g., the display module 160).

The processor 120 may execute, for example, software (e.g., a program 140) to control at least one other component (e.g., a hardware or software component) of the electronic device 101 coupled with the processor 120, and may perform various data processing or computation. According to an embodiment, as at least part of the data processing or computation, the processor 120 may store a command or data received from another component (e.g., the sensor module 176 or the communication module 190) in volatile memory 132, process the command or the data stored in the volatile memory 132, and store resulting data in non-volatile memory 134. According to an embodiment, the processor 120 may include a main processor 121 (e.g., a central processing unit (CPU) or an application processor (AP)), or an auxiliary processor 123 (e.g., a graphics processing unit (GPU), a neural processing unit (NPU), an image signal processor (ISP), a sensor hub processor, or a communication processor (CP)) that is operable independently from, or in conjunction with, the main processor 121. For example, when the electronic device 101 includes the main processor 121 and the auxiliary processor 123, the auxiliary processor 123 may be adapted to consume less power than the main processor 121, or to be specific to a specified function. The auxiliary processor 123 may be implemented as separate from, or as part of the main processor 121.

The auxiliary processor 123 may control at least some of functions or states related to at least one component (e.g., the display module 160, the sensor module 176, or the communication module 190) among the components of the electronic device 101, instead of the main processor 121 while the main processor 121 is in an inactive (e.g., sleep) state, or together with the main processor 121 while the main processor 121 is in an active state (e.g., executing an application). According to an embodiment, the auxiliary processor 123 (e.g., an image signal processor or a communication processor) may be implemented as part of another component (e.g., the camera module 180 or the communication module 190) functionally related to the auxiliary processor 123. According to an embodiment, the auxiliary processor 123 (e.g., the neural processing unit) may include a hardware structure specified for artificial intelligence model processing. An artificial intelligence model may be generated by machine learning. Such learning may be performed, e.g., by the electronic device 101 where the artificial intelligence is performed or via a separate server (e.g., the server 108). Learning algorithms may include, but are not limited to, e.g., supervised learning, unsupervised learning, semi-supervised learning, or reinforcement learning. The artificial intelligence model may include a plurality of artificial neural network layers. The artificial neural network may be a deep neural network (DNN), a convolutional neural network (CNN), a recurrent neural network (RNN), a restricted Boltzmann machine (RBM), a deep belief network (DBN), a bidirectional recurrent deep neural network (BRDNN), deep Q-network or a combination of two or more thereof but is not limited thereto. The artificial intelligence model may, additionally or alternatively, include a software structure other than the hardware structure.

The memory 130 may store various data used by at least one component (e.g., the processor 120 or the sensor module 176) of the electronic device 101. The various data may include, for example, software (e.g., the program 140) and input data or output data for a command related thereto. The memory 130 may include the volatile memory 132 or the non-volatile memory 134.

The program 140 may be stored in the memory 130 as software, and may include, for example, an operating system (OS) 142, middleware 144, or an application 146.

The input module 150 may receive a command or data to be used by another component (e.g., the processor 120) of the electronic device 101, from the outside (e.g., a user) of the electronic device 101. The input module 150 may include, for example, a microphone, a mouse, a keyboard, a key (e.g., a button), or a digital pen (e.g., a stylus pen).

The sound output module 155 may output sound signals to the outside of the electronic device 101. The sound output module 155 may include, for example, a speaker or a receiver. The speaker may be used for general purposes, such as playing multimedia or playing record. The receiver may be used for receiving incoming calls. According to an embodiment, the receiver may be implemented as separate from, or as part of the speaker.

The display module 160 may visually provide information to the outside (e.g., a user) of the electronic device 101. The display module 160 may include, for example, a display, a hologram device, or a projector and control circuitry to control a corresponding one of the display, hologram device, and projector. According to an embodiment, the display module 160 may include a touch sensor adapted to detect a touch, or a pressure sensor adapted to measure the intensity of force incurred by the touch.

The audio module 170 may convert a sound into an electrical signal and vice versa. According to an embodiment, the audio module 170 may obtain the sound via the input module 150, or output the sound via the sound output module 155 or a headphone of an external electronic device (e.g., an electronic device 102) directly (e.g., wiredly) or wirelessly coupled with the electronic device 101.

The sensor module 176 may detect an operational state (e.g., power or temperature) of the electronic device 101 or an environmental state (e.g., a state of a user) external to the electronic device 101, and then generate an electrical signal or data value corresponding to the detected state. According to an embodiment, the sensor module 176 may include, for example, a gesture sensor, a gyro sensor, an atmospheric pressure sensor, a magnetic sensor, an acceleration sensor, a grip sensor, a proximity sensor, a color sensor, an infrared (IR) sensor, a biometric sensor, a temperature sensor, a humidity sensor, or an illuminance sensor.

The interface 177 may support one or more specified protocols to be used for the electronic device 101 to be coupled with the external electronic device (e.g., the electronic device 102) directly (e.g., wiredly) or wirelessly. According to an embodiment, the interface 177 may include, for example, a high definition multimedia interface (HDMI), a universal serial bus (USB) interface, a secure digital (SD) card interface, or an audio interface.

A connecting terminal 178 may include a connector via which the electronic device 101 may be physically connected with the external electronic device (e.g., the electronic device 102). According to an embodiment, the connecting terminal 178 may include, for example, an HDMI connector, a USB connector, an SD card connector, or an audio connector (e.g., a headphone connector).

The haptic module 179 may convert an electrical signal into a mechanical stimulus (e.g., a vibration or a movement) or electrical stimulus which may be recognized by a user via his tactile sensation or kinesthetic sensation. According to an embodiment, the haptic module 179 may include, for example, a motor, a piezoelectric element, or an electric stimulator.

The camera module 180 may capture a still image or moving images. According to an embodiment, the camera module 180 may include one or more lenses, image sensors, image signal processors, or flashes.

The power management module 188 may manage power supplied to the electronic device 101. According to an embodiment, the power management module 188 may be implemented as at least part of, for example, a power management integrated circuit (PMIC).

The battery 189 may supply power to at least one component of the electronic device 101. According to an embodiment, the battery 189 may include, for example, a primary cell which is not rechargeable, a secondary cell which is rechargeable, or a fuel cell.

The communication module 190 may support establishing a direct (e.g., wired) communication channel or a wireless communication channel between the electronic device 101 and the external electronic device (e.g., the electronic device 102, the electronic device 104, or the server 108) and performing communication via the established communication channel. The communication module 190 may include one or more communication processors that are operable independently from the processor 120 (e.g., the application processor (AP)) and supports a direct (e.g., wired) communication or a wireless communication. According to an embodiment, the communication module 190 may include a wireless communication module 192 (e.g., a cellular communication module, a short-range wireless communication module, or a global navigation satellite system (GNSS) communication module) or a wired communication module 194 (e.g., a local area network (LAN) communication module or a power line communication (PLC) module). A corresponding one of these communication modules may communicate with the external electronic device via the first network 198 (e.g., a short-range communication network, such as Bluetooth^{™}, wireless-fidelity (Wi-Fi) direct, or infrared data association (IrDA)) or the second network 199 (e.g., a long-range communication network, such as a legacy cellular network, a 5G network, a next-generation communication network, the Internet, or a computer network (e.g., LAN or wide area network (WAN)). These various types of communication modules may be implemented as a single component (e.g., a single chip), or may be implemented as multi components (e.g., multi chips) separate from each other. The wireless communication module 192 may identify and authenticate the electronic device 101 in a communication network, such as the first network 198 or the second network 199, using subscriber information (e.g., international mobile subscriber identity (IMSI)) stored in the subscriber identification module 196.

The wireless communication module 192 may support a 5G network, after a 4G network, and next-generation communication technology, e.g., new radio (NR) access technology. The NR access technology may support enhanced mobile broadband (eMBB), massive machine type communications (mMTC), or ultra-reliable and low-latency communications (URLLC). The wireless communication module 192 may support a high-frequency band (e.g., the mmWave band) to achieve, e.g., a high data transmission rate. The wireless communication module 192 may support various technologies for securing performance on a high-frequency band, such as, e.g., beamforming, massive multiple-input and multiple-output (massive MIMO), full dimensional MIMO (FD-MIMO), array antenna, analog beam-forming, or large scale antenna. The wireless communication module 192 may support various requirements specified in the electronic device 101, an external electronic device (e.g., the electronic device 104), or a network system (e.g., the second network 199). According to an embodiment, the wireless communication module 192 may support a peak data rate (e.g., 20Gbps or more) for implementing eMBB, loss coverage (e.g., 164dB or less) for implementing mMTC, or U-plane latency (e.g., 0.5ms or less for each of downlink (DL) and uplink (UL), or a round trip of 1ms or less) for implementing URLLC.

The antenna module 197 may transmit or receive a signal or power to or from the outside (e.g., the external electronic device) of the electronic device 101. According to an embodiment, the antenna module 197 may include an antenna including a radiating element composed of a conductive material or a conductive pattern formed in or on a substrate (e.g., a printed circuit board (PCB)). According to an embodiment, the antenna module 197 may include a plurality of antennas (e.g., array antennas). In such a case, at least one antenna appropriate for a communication scheme used in the communication network, such as the first network 198 or the second network 199, may be selected, for example, by the communication module 190 (e.g., the wireless communication module 192) from the plurality of antennas. The signal or the power may then be transmitted or received between the communication module 190 and the external electronic device via the selected at least one antenna. According to an embodiment, another component (e.g., a radio frequency integrated circuit (RFIC)) other than the radiating element may be additionally formed as part of the antenna module 197.

According to various embodiments, the antenna module 197 may form a mmWave antenna module. According to an embodiment, the mmWave antenna module may include a printed circuit board, an RFIC disposed on a first surface (e.g., the bottom surface) of the printed circuit board, or adjacent to the first surface and capable of supporting a designated high-frequency band (e.g., the mmWave band), and a plurality of antennas (e.g., array antennas) disposed on a second surface (e.g., the top or a side surface) of the printed circuit board, or adjacent to the second surface and capable of transmitting or receiving signals of the designated high-frequency band.

At least some of the above-described components may be coupled mutually and communicate signals (e.g., commands or data) therebetween via an inter-peripheral communication scheme (e.g., a bus, general purpose input and output (GPIO), serial peripheral interface (SPI), or mobile industry processor interface (MIPI)).

According to an embodiment, commands or data may be transmitted or received between the electronic device 101 and the external electronic device 104 via the server 108 coupled with the second network 199. Each of the electronic devices 102 or 104 may be a device of a same type as, or a different type, from the electronic device 101. According to an embodiment, all or some of operations to be executed at the electronic device 101 may be executed at one or more of the external electronic devices 102, 104, or 108. For example, if the electronic device 101 should perform a function or a service automatically, or in response to a request from a user or another device, the electronic device 101, instead of, or in addition to, executing the function or the service, may request the one or more external electronic devices to perform at least part of the function or the service. The one or more external electronic devices receiving the request may perform the at least part of the function or the service requested, or an additional function or an additional service related to the request, and transfer an outcome of the performing to the electronic device 101. The electronic device 101 may provide the outcome, with or without further processing of the outcome, as at least part of a reply to the request. To that end, a cloud computing, distributed computing, mobile edge computing (MEC), or client-server computing technology may be used, for example. The electronic device 101 may provide ultra low-latency services using, e.g., distributed computing or mobile edge computing. In another embodiment, the external electronic device 104 may include an internet-of-things (IoT) device. The server 108 may be an intelligent server using machine learning and/or a neural network. According to an embodiment, the external electronic device 104 or the server 108 may be included in the second network 199. The electronic device 101 may be applied to intelligent services (e.g., smart home, smart city, smart car, or healthcare) based on 5G communication technology or IoT-related technology.

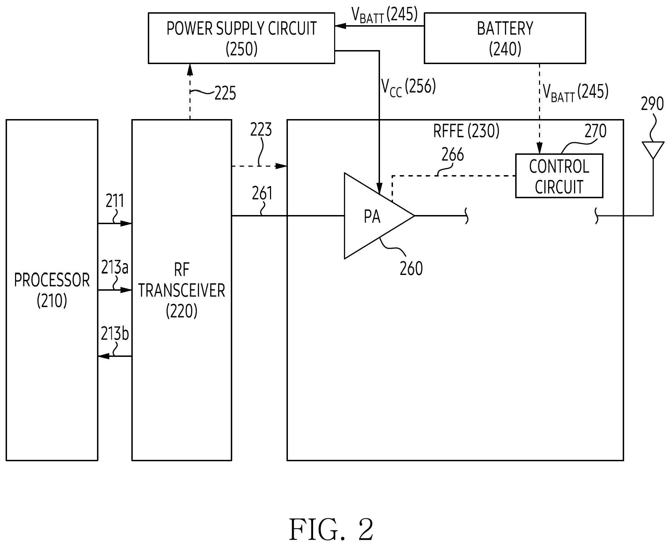

FIG. 2 represents an example of an electronic device (e.g., an electronic device 101) including a radio frequency end (RFFE) module.

Referring to FIG. 2, the electronic device 101 may include a processor 210, an RF transceiver 220, a radio frequency front end (RFFE) module 230, a battery 240, a power supply circuit 250 (e.g., a modulator), and an antenna 290. The electronic device 101 may include the processor 210. For example, the processor 210 may include at least one of an application processor (AP) (e.g., the main processor 121 of FIG. 1) or a communication processor (CP) (e.g., the auxiliary processor 123 of FIG. 1). For example, the processor 210 may include the AP and the CP. For example, the processor may include the AP. For example, the processor 210 may include the CP. The processor 210 may control the RF transceiver 220 through a control interface 211. For example, the processor 210 may generate a baseband signal. The processor 210 may control the RF transceiver 220 to process the generated baseband signal. The processor 210 may transmit a signal 213a (e.g., analog data or digital data). For example, the signal 213a may be a communication signal for being transmitted to an external electronic device (e.g., a base station, a satellite, a terminal, an electronic device 102, an electronic device 104, or a server 108). The processor 210 may control the RF transceiver 220 such that the signal is transmitted through an antenna 280. The processor 210 may receive a signal 213b (e.g., analog data or digital data). For example, the signal 213b may be a signal received from an external electronic device (e.g., the base station, the satellite, the terminal, the electronic device 102, the electronic device 104, or the server 108) through the antenna 280. For another example, the signal 213b may include a signal (e.g., a feedback signal) for measuring a transmit power. The processor 210 may control the RF transceiver 220 such that the signal 213b is received. For example, the processor 210 may obtain a feedback signal through a port (e.g., a feedback receive port (FBRX)) of the RF transceiver 220.

The electronic device 101 may include the RF transceiver 220. For example, the RF transceiver 220 may be implemented as a single chip (e.g., an RFIC chip) or as a part of a single package. The RF transceiver 220 may include a digital to analog converter (DAC) for converting a digital signal into an analog signal. The RF transceiver 220 may include a mixer and an oscillator (e.g., a local oscillator (LO)) for up-conversion. The RF transceiver 220 may convert the baseband signal generated by the processor 210 into an RF signal. For example, the RF transceiver 220 may provide an RF signal 261 to the RFFE module 230. The RF transceiver 220 may include an analog to digital converter (ADC) for converting an analog signal into an digital signal. The RF transceiver 220 may include a mixer and an oscillator for down-conversion. The RF transceiver 220 may convert an RF signal received from the antenna 280 into a baseband signal such that it may be processed by the processor 210. The RF transceiver 220 may include one or more transmission ports. The RF transceiver 220 may include one or more reception ports. Although not illustrated in FIG. 2, the RF transceiver 220 may receive a feedback signal provided from a component (e.g., a coupler 235) of the RFFE module 230 electrically connected with the antenna 290. For example, the RF transceiver 220 may include a feedback receive port (FBRX) for a feedback signal. According to an embodiment, the RF transceiver 220 may control at least a part of the RFFE module 230 through a control interface 223 (e.g., a mobile industry processor interface (MIPI)). According to an embodiment, the RF transceiver 220 may control at least a part of the power supply circuit 250 through a control interface 225 (e.g., a MIPI).

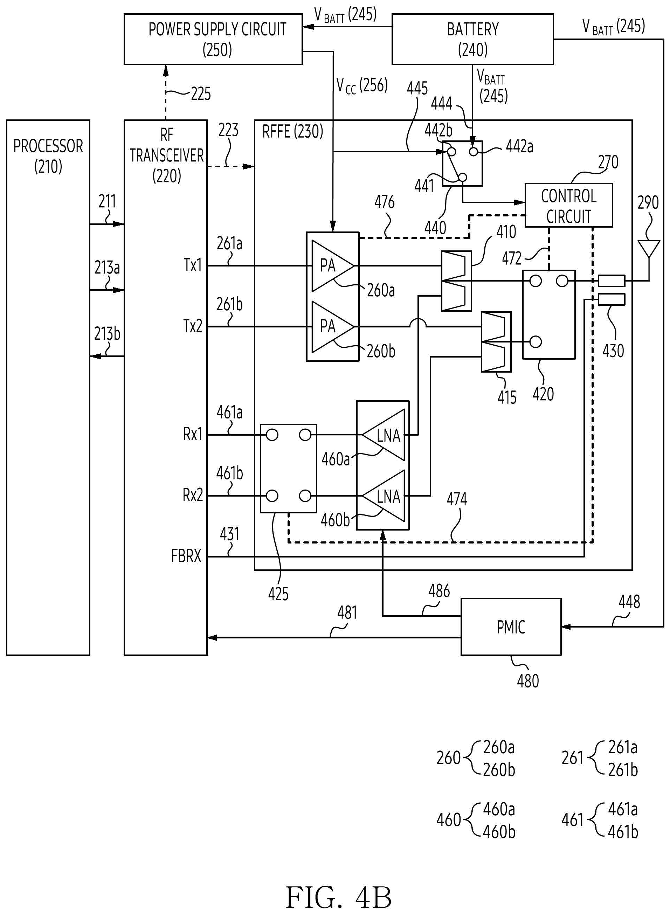

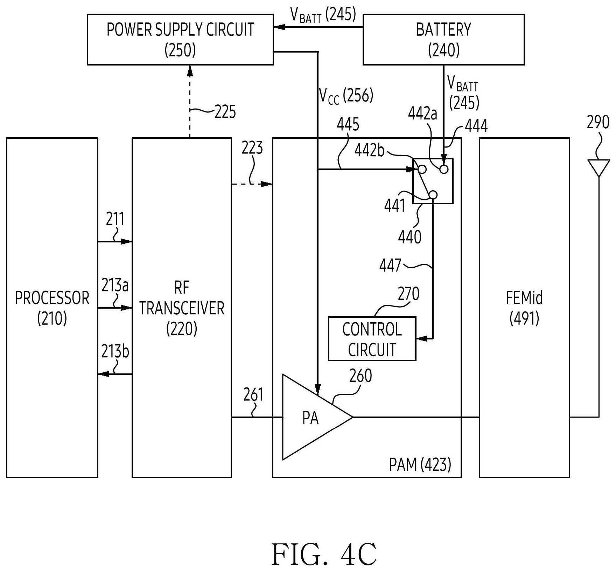

The electronic device 101 may include the RFFE module 230. A wireless communication system is developing in a direction for supporting a higher data transmission rate to meet an ever-increasing traffic demand for wireless data. In order to support various frequency combinations, components of a plurality of transmit (TX)/receive (RX) modules (e.g., the RFFE module 230) may be disposed around the RF transceiver 220. In the present disclosure, the RFFE module 230 may indicate a module including a power amplifier (PA) 260 for the RF signal 261 in the RFFE. For example, the RFFE module 230 may be a PAMid including the power amplifier 260 and RF components (e.g., a duplexer, a filter, or a switch) for processing a transmission signal. For example, the RFFE module 230 may be an LPAMid including an LNA exemplified in FIG. 4B. For example, the RFFE module 230 may be a power amplifier module including the power amplifier 260 and a control circuit of the power amplifier 260 exemplified in FIG. 4C. The RFFE module 230 may be configured to transmit a transmission signal (e.g., the RF signal 261) from the RF transceiver 220 to the antenna 290. The RF signal 261 from the RF transceiver 220 may be amplified by the power amplifier 260. The amplified RF signal may be radiated into the air through the antenna 290. Although not illustrated in FIG. 2, the RFFE module 230 may include components for a reception path in addition to components for a transmission path. The RFFE module 230 may include a low noise amplifier (LNA) (not illustrated) for the reception path. The RFFE module 230 may include a control circuit 270 for controlling a switch within the RFFE module 230 or for controlling a bias voltage of the power amplifier 260. The control circuit 270 of the present closure may be used to control internal components of a communication module (e.g., the RFFE module 230). In addition to the control circuit, the control circuit 270 may be used as a term such as a control unit, a controller, a control circuit, a logic circuit, a complementary metal-oxide-semiconductor (CMOS) controller, a CMOS logic circuit, a CMOS control circuit, a control logic circuit, an RFFE controller, an RFFE control circuit, an RFFE module control circuit, and/or a term having an equivalent technical/functional meaning.

For a power supply of components in the RFFE module 230, the electronic device 101 may include the battery 240, the power supply circuit 250, and a power management integrated circuit (PMIC) (not illustrated) (e.g., the power management module 188). The battery 240 may be used to drive the RFFE module 230, the power supply circuit 250, and the PMIC. For example, the battery 240 may provide a battery voltage 245. As a term indicating a voltage (e.g., the battery voltage 245) of the battery 240 of the present disclosure, in addition to the battery voltage, a battery power and/or a term having an equivalent technical/functional meaning may be used. The power supply circuit 250 may be configured to supply a voltage (hereinafter, a supply voltage) V_{cc} to the power amplifier (PA) 260 of the RFFE module 230. The power supply circuit 250 may generate a supply voltage 256 based on the battery voltage 245 V_{BATT} supplied from the battery 240. For example, the power supply circuit 250 may generate the supply voltage 256 through boosting and/or lowering the battery voltage 245. In order to generate the supply voltage 256, the power supply circuit 250 may include at least one circuit for DC-DC converting. For example, the power supply circuit 250 may include a buck converter circuit, a boost converter circuit, and a regulator for envelope tracking (ET). The boost converter circuit may be used to supply a voltage higher than the battery voltage 245, and the buck converter circuit may be used to supply a voltage lower than the battery voltage 245. The power supply circuit 250 may provide the supply voltage 256 to the power amplifier 260 based on the buck converter circuit and the boost converter circuit. For example, the power supply circuit 250 may provide the supply voltage 256 to the power amplifier 260 based on APT. The APT is a technology for supplying a power to the power amplifier 260 by a specified magnitude through the DC-DC converting. The power supply circuit 250 may provide the supply voltage 256 to the power amplifier 260 based on the buck converter circuit, the boost converter circuit, and the regulator. For example, the power supply circuit 250 may provide the supply voltage 256 to the power amplifier 260 based on the ET. The ET is a technology for supplying a power to the power amplifier 260 by a magnitude corresponding to an envelope of a transmission signal. As a term referring to a voltage (e.g., the supply voltage 256) applied to the power amplifier 260 of the present closure, in addition to the supply voltage, a supply power, an amplifier power, an operating voltage for a power amplifier, an operating power, a power amplifier power, and/or a term having an equivalent technical/functional meaning may be used.

The PMIC may be used to provide a power to the RF transceiver 220. As an example, the PMIC may supply a voltage equal to or less than approximately 2V to the RF transceiver 220. As a non-limiting example, the PMIC may supply a power to a low noise amplifier (LNA) within the RFFE module 230. As an example, the PMIC may supply a voltage equal to or less than approximately 2V to the LNA.

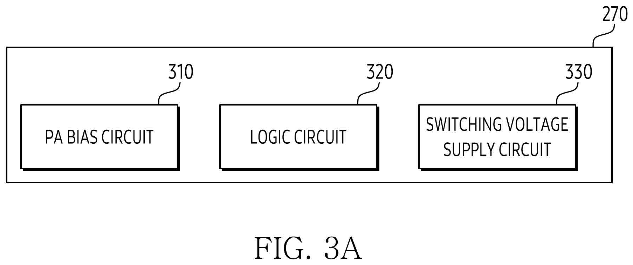

The RFFE module 230 may receive a plurality of powers for components within the RFFE module 230. For example, the RFFE module 230 may obtain the supply voltage 256 applied to the power amplifier 260. For example, the RFFE module 230 may obtain the battery voltage 245 for an operation of the control circuit 270. For example, the RFFE module 230 may obtain a voltage for the LNA (not illustrated) within the RFFE module 230. For example, the control circuit 270 of the RFFE module 230 may be configured to control a bias voltage of the power amplifier 260 of the RFFE module 230 or a logic circuit and/or at least one switch within the RFFE module 230. Accordingly, the control circuit 270 may be required to supply a voltage having a sufficient magnitude. Since using the battery 240 causes a decrease in the battery voltage 245, if the battery voltage 245 is equal to or less than a predetermined threshold (hereinafter, a voltage threshold) (e.g., approximately 3.4 V and approximately 3.2 V), the control circuit 270 may be difficult to operate normally. For example, as a bias voltage 266 is not sufficiently provided to the power amplifier 260 through the control circuit 270, it may cause a problem in transmission performance of the electronic device 101. A specific example is described through FIGS. 3A to 3B.

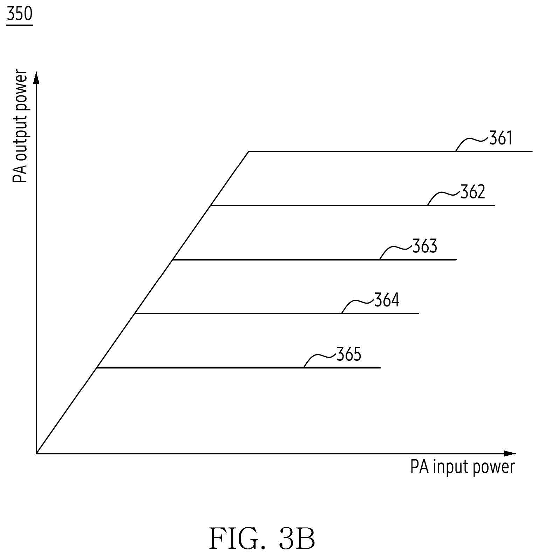

FIG. 3A represents an example of a control circuit (e.g., a control circuit 270) of an RFFE module (e.g., an RFFE module 230). FIG. 3B represents a relationship between a control circuit (e.g., the control circuit 270) of an RFFE module and performance of a power amplifier (e.g., a power amplifier 260). The same reference numbers may be used for the same description.

Referring to FIG. 3A, the control circuit 270 may include a PA bias circuit 310 (e.g., a current digital to analog converter (IDAC) circuit), a logic circuit 320, and a switching voltage supply circuit 330. If a magnitude of a voltage supplied to the control circuit 270 is lowered (e.g., if a magnitude of a battery voltage 245 is lowered than a voltage threshold), an amount of a current/voltage supplied by the PA bias circuit 310 to the power amplifier 260 may not be sufficient. Accordingly, it may be difficult for the PA bias circuit 310 to operate normally. If the battery voltage 245 is lowered than the voltage threshold in a case that the battery voltage 245 is supplied to the control circuit 270, the PA bias circuit 310 may not operate normally, and thus a problem may occur in linearity and an output of the power amplifier 260. For example, a graph 350 of FIG. 3B represents a characteristic of the power amplifier 260 according to a current supplied to the PA bias circuit 310. A horizontal axis of the graph 350 represents an input power, and a vertical axis of the graph 350 represents an output power. A magnitude of the current supplied to the PA bias circuit 310 is high in an order of a first line 361, a second line 362, a third line 363, a fourth line 364, and a fifth line 365. As illustrated in the graph 350, as the current supplied to the PA bias circuit 310 is decreased, a gain of the power amplifier 260 is decreased and a saturation level is decreased.

If the magnitude of the voltage supplied to the control circuit 270 as well as a magnitude of a voltage (e.g., the supply voltage 256 V_{cc}) supplied to the power amplifier 260 (e.g., if the magnitude of the battery voltage 245 is lowered than the voltage threshold), a logic circuit controlled through the logic circuit 320 and/or switching module(s) controlled through the switching voltage supply circuit 330 may not operate normally. For example, as a switching module does not operate at a switching time point, a component may be damaged. In order to reduce the above-described problem, in the present disclosure, even if the battery voltage 245 is lowered, a technology for stably securing RF performance using the RFFE module 230 is described.

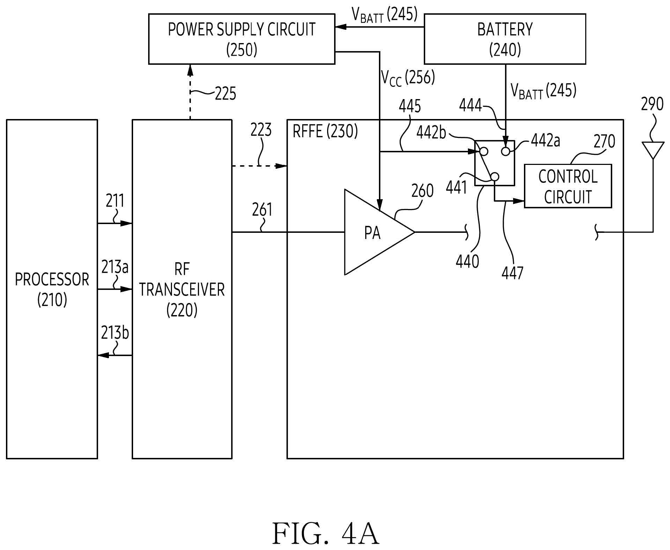

FIGS. 4A, 4B, and 4C represent an example of an RFFE module (e.g., the RFFE module 230 of FIG. 2) including a control circuit (e.g., the control circuit 270 of FIGS. 2 and 3A) and a switching circuit for providing a voltage to the control circuit. The same reference numbers may be used for the same description.

Referring to FIG. 4A, an electronic device 101 may include a processor 210, an RF transceiver 220, an RFFE module 230, a battery 240, a power supply circuit 250 (e.g., a modulator), and an antenna 290. For components of the electronic device 101, FIG. 2 may be referenced. In the present disclosure, the RFFE module 230 may indicate a module including a power amplifier (PA) 260 for a RF signal 261 in an RFFE. For example, the RFFE module 230 may be a PAMid including the power amplifier 260 and RF components (e.g., a duplexer, a filter, or a switch) for processing a transmission signal. For example, the RFFE module 230 may be an LPAMid including an LNA exemplified in FIG. 4B. For example, the RFFE module 230 may be a power amplifier module including the power amplifier 260 and a control circuit of the power amplifier 260 exemplified in FIG. 4C.

A control circuit 270 may be used to control a switch within the RFFE module 230 or to control a bias voltage of the power amplifier 260. A supply voltage with a sufficient magnitude is required for a normal operation of the control circuit 270. Therefore, if a magnitude of a battery voltage 245 is lower than a voltage threshold, the electronic device 101 (e.g., a processor 210) according to an embodiment of the present disclosure may supply, to the control circuit 270, a voltage from another power (e.g., the power supply circuit 250) instead of the battery voltage 245.

As the power amplifier 260 requires a supply voltage in various voltage ranges (e.g., a wide range higher than or equal to approximately 0.5V to 5V), the power supply circuit 250 may be used. The power supply circuit 250 may include at least one circuit (e.g., a buck converter circuit, a boost converter circuit, or a regulator) for DC-DC converting. For example, the power supply circuit 250 may generate a supply voltage 256 higher than the battery voltage 245 based on the boost converter circuit. The power supply circuit 250 may generate the supply voltage 256 higher than the voltage threshold even if the battery voltage 245 is lower than the voltage threshold. The electronic device 101 according to embodiments of the present disclosure may use the power supply circuit 250, as a power to be used instead of the battery voltage 245.

According to an embodiment, the RFFE module 230 may include a switching circuit 440. For example, the switching circuit 440 may be configured to selectively and electrically connect the battery 240 or the power supply circuit 250 to the control circuit 270. The battery voltage 245 of the battery 240 or the supply voltage 256 of the power supply circuit 250 may be supplied to the control circuit 270 through the switching circuit 440. As an example, the switching circuit 440 may include a single pole double throw (SPDT). A pole 441 of the switching circuit 440 may be electrically connected to a first throw 442a or a second throw 442b. The pole 441 may be electrically connected to the control circuit 270 through a wiring 447. The first throw 442a may be electrically connected to the battery 240. For example, through a battery line 444 in the RFFE module 230, the first throw 442a may be electrically connected to the battery 240. While the switching circuit 440 connects the first throw 442a and the pole 441, the battery voltage 245 may be supplied to the control circuit 270. The second throw 442b may be electrically connected to a power line 445 to which the supply voltage 256 of the power supply circuit 250 is transmitted. For example, the supply voltage 256 of the power supply circuit 250 may be provided to the second throw 442b through the power line 445 connected to the second throw 442b. While the switching circuit 440 connects the second throw 442b and the pole 441, the supply voltage 256 may be supplied to the control circuit 270 through the power line 445.

According to an embodiment, the electronic device 101 (e.g., the processor 210) may monitor a magnitude of the battery voltage 245 of the battery 240. If the battery voltage 245 is higher than or equal to a voltage threshold (e.g., approximately 3.4V, 3.2V, or 3.1V), the electronic device 101 may control the switching circuit 440 such that the battery voltage 245 is supplied to the control circuit 270. For example, the electronic device 101 may identify that the battery voltage 245 is higher than or equal to the voltage threshold, while the switching circuit 440 electrically connects the power supply circuit 250 and the control circuit 270. The electronic device 101 may transmit a control signal to the switching circuit 440 of the RFFE module 230 to supply the battery voltage 245 higher than or equal to the voltage threshold. The control signal may cause switching of the switching circuit 440. In response to the control signal, the switching circuit 440 may electrically connect the battery 240 and the control circuit 270. If the battery voltage 245 is lower than the voltage threshold, the electronic device 101 may control the switching circuit 440 such that the supply voltage 256 of the power supply circuit 250 is supplied to the control circuit 270. For example, the electronic device 101 may identify that the battery voltage 245 is lower than the voltage threshold, while the switching circuit 440 electrically connects the battery 240 and the control circuit 270. The electronic device 101 may transmit, as a voltage equal to or greater than the voltage threshold, a control signal to the switching circuit 440 of the RFFE module 230 to use the supply voltage 256. The control signal may cause switching of the switching circuit 440. In response to the control signal, the switching circuit 440 may electrically connect the power supply circuit 250 and the control circuit 270.

As a reference for triggering the switching circuit 440 of the present disclosure, the voltage threshold may be referred to in various terms. In addition to the voltage threshold, the voltage threshold may be used as a term such as a battery threshold, a voltage threshold, an operation threshold, a threshold for an RFFE module operation, a threshold for a normal operation, a guarantee threshold, a minimum operation threshold, an IDAC threshold, a PA bias threshold, and/or a term having an equivalent technical/functional meaning.

In order to continuously supply a voltage higher than or equal to a voltage threshold to the control circuit 270, a magnitude of the supply voltage 256 may be required to be higher than or equal to the voltage threshold. Therefore, the electronic device 101 may control the power supply circuit 250 such that the supply voltage 256 higher than or equal to the voltage threshold is provided. In addition, since the power supply circuit 250 operates based on the battery voltage 245, the electronic device 101 may control the power supply circuit 250 such that the power supply circuit 250 is in a continuously turned-on state.

Since a transmit power of a transmission signal (e.g., the RF signal 261) of the power amplifier 260 is low, a situation in which a voltage lower than the voltage threshold is supplied may occur. According to an embodiment, the electronic device 101 (e.g., the processor 210) may control the power supply circuit 250 such that the supply voltage 256 does not become lower than the voltage threshold even if the transmit power is lowered. For example, the electronic device 101 may set all supply power values corresponding to a specific transmit power level to be higher than or equal to the voltage threshold through a value stored in memory (e.g., a non-volatile memory 134). While the power supply circuit 250 and the control circuit 270 are connected through the switching circuit 440, the supply voltage 256 of the power supply circuit 250 may be maintained to be greater than or equal to the voltage threshold. Since a gain of the power amplifier 260 does not change significantly unless it is in a saturation state, a problem in output performance of the power amplifier 260 may not occur due to the supply voltage 256 increased to be greater than or equal to the voltage threshold despite a low transmit power. In addition, since the electronic device 101 measures the transmit power in real time and controls the transmit power through a feedback port (e.g., feedback receive (FBRX) and a coupler (not illustrated)) of the RF transceiver 220, the problem in the output performance of the power amplifier 260 may not occur.

According to an embodiment, switching of the switching circuit 440 may be performed based on the voltage threshold. According to an embodiment, the voltage threshold may be set to be higher than or equal to a voltage guaranteed for components of the RFFE module 230 to perform a normal operation. For example, the voltage threshold may be set to be higher than or equal to a voltage value (e.g., 3.2V) for a normal operation of the PA bias circuit 310 of the control circuit 270. For example, the voltage threshold may be set to be higher than or equal to a voltage value required for a switch, a switching module, and/or a logic circuit within the RFFE module 230 to operate normally. According to an embodiment, switching of the switching circuit 440 may be controlled by the processor 210 and/or the RF transceiver 220. For example, the RF transceiver 220 may transmit a control signal through a control interface 223 (e.g., a mobile industry processor interface (MIPI)) based on the processor 210. The RFFE module 230 may control the switching circuit 440 based on the control signal. For example, the switching circuit 440 may be switched based on the control signal received through a RFFE bus within the RFFE module 230. As a non-limiting example, for switching according to the control signal, at least one logic circuit may be implemented within the RFFE module 230.

As a non-limiting example, the processor 210 may not perform switching of the switching circuit 440 in a case that the electronic device 101 is on a call or transmitting/receiving a signal. For example, the processor 210 may perform switching of the switching circuit 440 when a component (e.g., the RFFE module 230 or the power supply circuit 250) is in a sleep state. As an example, in the sleep state, the processor 210 may activate the power supply circuit 250 based on obtaining a wake-up request. As the power supply circuit 250 is activated, the switching circuit 440 may transmit the supply voltage 256 from the power supply circuit 250 to the control circuit 270.

In FIG. 4A, the RFFE module 230 including the power amplifier 260 is exemplified, but embodiments of the present disclosure are not limited to a specific type of module (e.g., the PAMid). In a case of an RFFE module including the power amplifier 260, embodiments of the present disclosure may be applied regardless of a type of the RFFE module. For example, the LPAMid, which is a module including the LNA for a reception signal, may also be understood as an example of the RFFE module 230. Hereinafter, through FIG. 4B, the switching circuit 440 for controlling a power to be supplied to the control circuit 270 disposed within the LPAMid will be described.

Referring to FIG. 4B, the electronic device 101 may include the processor 210, the RF transceiver 220, the RFFE module 230, the battery 240, the power supply circuit 250 (e.g., the modulator), and an antenna 290. For the components of the electronic device 101, FIGS. 2 to 4A may be referenced. The RFFE module 230, which is a component for a transmission signal, may include a first power amplifier 260a or a second power amplifier 260b. The RF transceiver 220 may transmit a first RF signal 261a to the first power amplifier 260a. The first RF signal 261a may be amplified by the first power amplifier 260a, and the amplified first RF signal 261a may be radiated through the antenna 290. The RF transceiver 220 may transmit the second RF signal 261b to the second power amplifier 260b. The second RF signal 261b may be amplified by the second power amplifier 260b, and the amplified second RF signal 261b may be radiated through the antenna 290. The RFFE module 230, which is components for a reception signal, may include a first low noise amplifier 460a and/or a second low noise amplifier 460b. The signals received through the antenna 290 may be amplified through the first low noise amplifier 460a or the second low noise amplifier 460b. The amplified reception signals (e.g., a first reception signal 461a or a second reception signal 461b) may be transmitted to the RF transceiver 220. In order to distinguish a transmission path from a reception path, the RFFE module 230 may include a first duplexer 410 and/or a second duplexer 415. For example, the first duplexer 410 may be used to distinguish a transmission frequency (e.g., an uplink frequency) of a first transmission signal of the first power amplifier 260a from a reception frequency (e.g., a downlink frequency) of a reception signal of the first low noise amplifier 460a. For example, the second duplexer 415 may be used to distinguish a transmission frequency (e.g., an uplink frequency) of a second transmission signal of the second power amplifier 260b from a reception frequency (e.g., a downlink frequency) of a reception signal of the second low noise amplifier 460b. A first output of the first low noise amplifier 460a and a second output of the second low noise amplifier 460b may be transmitted to the RF transceiver 220. As a non-limiting example, the RFFE module 230 may include a switch 425. The switch 425 may be configured to control whether to transmit respectively the first output and the second output to a first receive port RX1 and a second receive port RX2 of the RF transceiver 220 or to transmit respectively the second output and the first output to the first receive port RX1 and the second receive port RX2.

According to an embodiment, the RFFE module 230 may include a path switch 420. The path switch 420 may be configured to select a transmission path of a transmission signal to be transmitted through the antenna 290 from among a plurality of transmission paths of the RFFE module 230. The path switch 420 may be configured to electrically connect one of an output of the first duplexer 410 and an output of the second duplexer 415 to a coupler 430 and the antenna 290. For example, one of the first transmission signal (e.g., the amplified first RF signal) and the second transmission signal (e.g., the amplified second RF signal) may be radiated through the antenna 290 according to a state of the path switch 420. For example, a signal received through the antenna 290 may be provided to the first low noise amplifier 460a or the second low noise amplifier 460b, according to the state of the path switch 420.

According to an embodiment, the RFFE module 230 may include the coupler 430. The coupler 430 may be configured to transmit a part of a transmission signal to be transmitted through the antenna 290 to the RF transceiver 220 through a feedback path 431. The RF transceiver 220 may receive signals fed back through the feedback path 431 through the coupler 430. For example, the RF transceiver 220 may include the feedback receive port (FBRX) for the feedback path 431. The electronic device 101 (e.g., the processor 210) may control a transmit power through the feedback port (e.g., feedback receive (FBRX)) and the coupler 430 of the RF transceiver 220. According to an embodiment, as the transmit power is controlled in real time through the coupler 430 even if the supply voltage 256 to the power amplifier 260 is increased for a power supply to the switching circuit 440, output performance of the power amplifier 260 may be maintained.

According to an embodiment, the electronic device 101 may include a PMIC 480. The PMIC 480 may be used to provide a power to the RF transceiver 220. The PMIC 480 may obtain the battery voltage 245 through a wiring 448. The PMIC 480 may generate a supply voltage (e.g., a voltage 481 or a voltage 486) based on the battery voltage 245. For example, the PMIC 480 may supply the voltage 481 (e.g., approximately 2V) for driving the RF transceiver 220 to the RF transceiver 220. For example, the PMIC 480 may supply the voltage 486 (e.g., approximately 1.8V) to low noise amplifiers (e.g., the first low noise amplifier 460a or the second low noise amplifier 460b) within the RFFE module 230.

According to an embodiment, the control circuit 270 may be configured to control a bias voltage of a power amplifier (e.g., the first power amplifier 260a or the second power amplifier 260b) of the RFFE module 230 or a logic circuit and/or at least one switch (e.g., the path switch 420 and/or the switch 425) within the RFFE module 230. For example, the control circuit 270 may be configured to control an operation of the path switch 420 through a control path 472 or to supply a voltage to the path switch 420. For example, the control circuit 270 may be configured to control an operation of the switch 425 through a control path 474 or to supply a voltage to the switch 425. For example, the control circuit 270 may be configured to provide a bias voltage for the first power amplifier 260a and/or the second power amplifier 260b through a control path 476. Since the power amplifier 260 operates in various voltage ranges, the control circuit 270 may be required to receive a voltage higher than or equal to a certain value (e.g., approximately 3V) in order to stably supply the bias voltage. The electronic device 101 may use the power supply circuit 250 instead of the PMIC 480 in order to supply the voltage higher than or equal to the certain value to the control circuit 270. The switching circuit 440 may be configured to selectively and electrically connect the battery 240 or the power supply circuit 250 to the control circuit 270. The battery voltage 245 of the battery 240 or the supply voltage 256 of the power supply circuit 250 may be supplied to the control circuit 270 through the switching circuit 440.

In FIG. 4B, a transmission path and a reception path for a frequency division duplex (FDD) frequency band in which uplink and downlink are distinguished in a frequency domain are exemplified, but embodiments of the present disclosure are not limited thereto. For switching between a transmission path and a reception path for a time division duplex (TDD) frequency band, the RFFE module 230 may include a switching circuit instead of the first duplexer 410 or the second duplexer 415.

Not only a module such as the LPAMid exemplified in FIG. 4B, but also a power amplifier module (e.g., the PA module) implemented separately from RF components (e.g., the duplexer, or the filter) may be understood as an example of the RFFE module 230. A transmission path from the RF transceiver 220 to the antenna 290 may be formed through a module including the power amplifier and a separate FEMid. Hereinafter, through FIG. 4C, the switching circuit 440 for controlling a power to be supplied to the control circuit 270 disposed within a power amplifier module will be described.

Referring to FIG. 4C, the electronic device 101 may include the processor 210, the RF transceiver 220, a power amplifier module 423, an FEMid 491, the battery 240, the power supply circuit 250 (e.g., the modulator), and the antenna 290. Unlike illustrated in FIGS. 4A and 4B, the RFFE may be divided into the power amplifier module 423 including a power amplifier and the FEMid 491. The antenna 290 may be electrically connected to the FEMid 491. The FEMid 491 may include RF components and/or an antenna switching module for signal transmission. For example, the FEMid 491 may include a duplexer, an RF filter, and/or a coupler.

According to an embodiment, the power amplifier module 423 may include the power amplifier 260, the control circuit 270 for the power amplifier 260, and the switching circuit 440. The control circuit 270 may be used to control a switch (e.g., the switching circuit 440) within the RFFE module 230 or to control a bias voltage of the power amplifier 260. A supply voltage of a sufficient magnitude is required for a normal operation of the control circuit 270. Therefore, if a magnitude of the battery voltage 245 is lower than a voltage threshold, the electronic device 101 (e.g., the processor 210) according to embodiments of the present disclosure may supply, to the control circuit 270, a voltage from another power (e.g., the power supply circuit 250) instead of the battery voltage 245. For description of each of elements of the power amplifier module 423, FIG. 4A may be referenced. The switching circuit 440 may be configured to selectively and electrically connect the battery 240 or the power supply circuit 250 to the control circuit 270. The battery voltage 245 of the battery 240 or the supply voltage 256 of the power supply circuit 250 may be supplied to the control circuit 270 through the switching circuit 440.

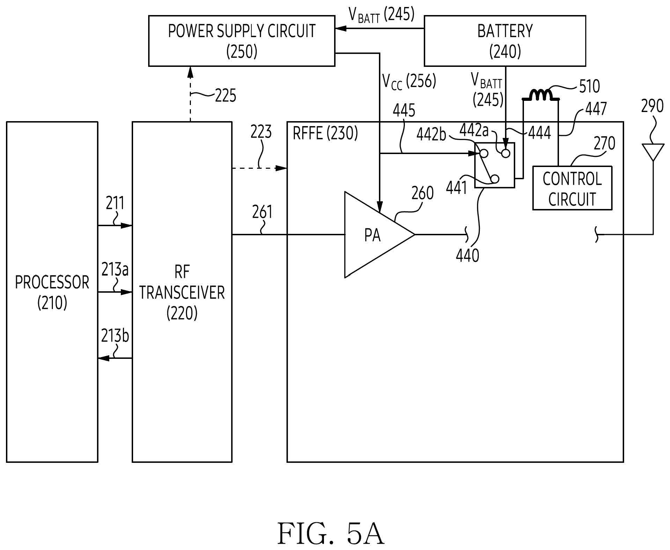

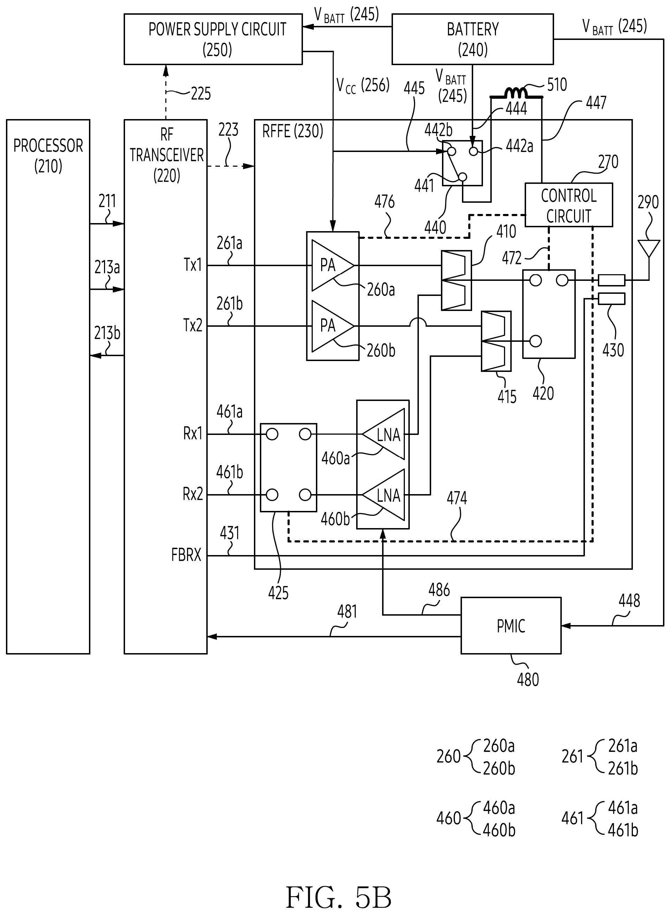

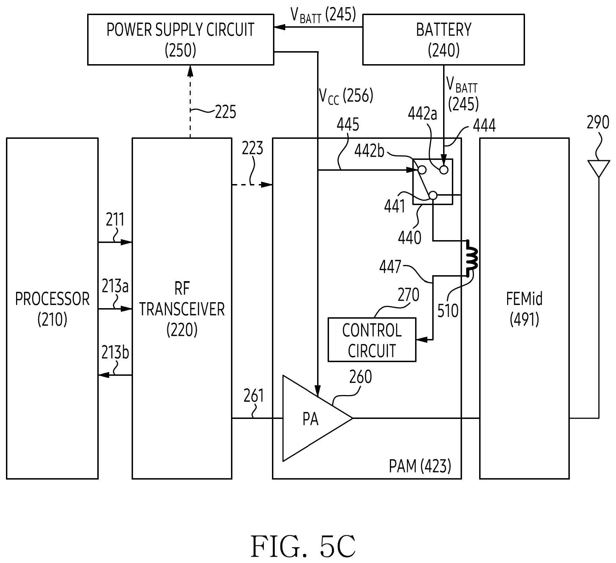

FIGS. 5A, 5B, and 5C represent an example of an electronic device (e.g., an electronic device 101) including an RFFE module (e.g., an RFFE module 230) connected to an inductor.

Referring to FIG. 5A, the electronic device 101 may include a processor 210, an RF transceiver 220, an RFFE module 230, a battery 240, a power supply circuit 250 (e.g., a modulator), and an antenna 290. For components of the electronic device 101, the descriptions of FIG. 4A may be referenced. The RFFE module 230 may include a control circuit 270. The control circuit 270 may be used to control a switch within the RFFE module 230 or to control a bias voltage of a power amplifier 260. If a magnitude of the battery voltage 245 is lower than a voltage threshold, the electronic device 101 (e.g., the processor 210) according to embodiments of the present disclosure may supply, to the control circuit 270, a voltage from another power (e.g., the power supply circuit 250) instead of the battery voltage 245. According to an embodiment, the RFFE module 230 may include a switching circuit 440. The switching circuit 440 may be configured to selectively and electrically connect the battery 240 or the power supply circuit 250 to the control circuit 270.

According to an embodiment, the power supply circuit 250 may be connected to the switching circuit 440 through a power line 445. A supply voltage 256 of the power supply circuit 250 may be supplied to the control circuit 270 through the power line 445. Meanwhile, the power supply circuit 250 may cause noise in generating the supply voltage 256. For example, noise may occur together with the supply voltage 256 due to switching during an ET operation and/or switching during an APT operation of the power supply circuit 250. If the noise is introduced into the control circuit 270, performance of the control circuit 270 may be deteriorated. In addition, as a non-limiting example, if the control circuit 270 includes a power amplifier (e.g., a pre-driver amplifier), an inflow of external noise may cause more serious performance degradation. According to an embodiment, the switching circuit 440 may be connected to an inductor 510 to reduce this external noise. The switching circuit 440 may be connected to the control circuit 270 through the inductor 510. For example, the switching circuit 440 may include an SPDT. A pole 441 of the switching circuit 440 may be connected to the inductor 510 through a wiring 447. The inductor 510 may be connected to the control circuit 270. According to an embodiment, the inductor 510 may be positioned outside the RFFE module 230. For connection to the inductor 510 disposed outside the RFFE module 230, the wiring 447 of the switching circuit 440 may be used. The wiring 447 may be electrically connected to the inductor 510 disposed outside through at least one port of the RFFE module 230.

Implementation of the inductor 510 described in FIG. 5A may be applied in substantially the same manner not only to the RFFE 230 exemplified in FIG. 4A, but also to the RFFEs exemplified in FIGS. 4B and 4C.

Referring to FIG. 5B, the electronic device 101 may include the processor 210, the RF transceiver 220, the RFFE module 230, the battery 240, the power supply circuit 250 (e.g., the modulator), and the antenna 290. For components of the electronic device 101, the descriptions of FIG. 4B may be referenced. According to an embodiment, the switching circuit 440 of the RFFE module 230 may be connected to the inductor 510. The switching circuit 440 may be electrically connected to the control circuit 270 through the inductor 510. For example, the switching circuit 440 may include the SPDT. The RFFE module 230 may include at least one port for electrically connecting the pole 441 of the switching circuit 440 and the inductor 510. Within the RFFE module 230, the at least one port of the RFFE module 230 may electrically connect the pole 441 and the control circuit 270 through the wiring 447. The inductor 510 disposed outside the RFFE module 230 may be connected to the at least one port of the RFFE module 230. The wiring 447 may be electrically connected to the inductor 510 disposed outside, through at least one port of the RFFE module 230.

Referring to FIG. 5C, the electronic device 101 may include the processor 210, the RF transceiver 220, a power amplifier module 423, an FEMid 491, the battery 240, the power supply circuit 250 (e.g., the modulator), and the antenna 290. For the components of the electronic device 101, the descriptions of FIG. 4B may be referenced. According to an embodiment, the switching circuit 440 of the power amplifier module 423 may be connected to the inductor 510. The switching circuit 440 may be electrically connected to the control circuit 270 through the inductor 510. For example, the switching circuit 440 may include the SPDT. The power amplifier module 423 may include at least one port for electrically connecting the pole 441 of the switching circuit 440 and the inductor 510. Within the power amplifier module 423, the at least one port of the power amplifier module 423 may electrically connect the pole 441 and the control circuit 270 through the wiring 447. The inductor 510 disposed outside the power amplifier module 423 may be connected to the at least one port of the power amplifier module 423. The wiring 447 may be electrically connected to the inductor 510 disposed outside, through at least one port of the power amplifier module 423.

In FIGS. 5A to 5C, it is illustrated that the inductor 510 is disposed outside the RFFE module 230, but embodiments of the present disclosure are not limited thereto. According to another embodiment, the inductor 510 may be positioned within the RFFE module 230. For example, in order to utilize an external space, the inductor 510 may be disposed in the RFFE module 230.

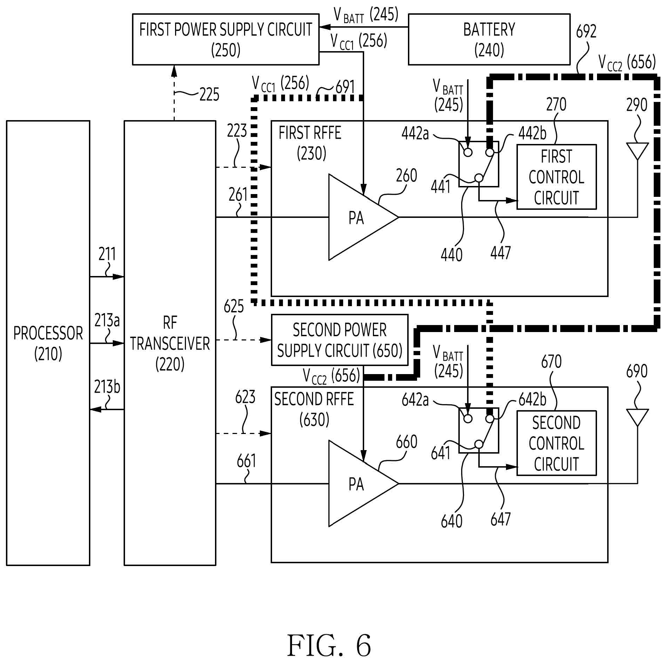

FIG. 6 represents an example of an electronic device (e.g., an electronic device 101) including a plurality of RFFE modules and a plurality of power supply circuits. The same reference numbers may be used for the same description.

Referring to FIG. 6, the electronic device 101 may include a processor 210, an RF transceiver 220, and a battery 240. In order to support various frequency combinations, the electronic device 101 may include a plurality of TX/RX modules. For example, the electronic device 101 may include a first RFFE module 230 and a second RFFE module 630. The first RFFE module 230 may be connected to a first antenna 290. The second RFFE module 630 may be connected to a second antenna 690. For each TX/RX module, the electronic device 101 may include a plurality of power supply circuits (e.g., a modulator). For example, the electronic device 101 may include a first power supply circuit 250 for the first RFFE module 230 and a second power supply circuit 650 for the second RFFE module 630. The first RFFE module 230 may be configured to transmit a transmission signal (e.g., a first RF signal 261) from the RF transceiver 220 to the antenna 290. The first RFFE module 230 may include a first power amplifier 260 for a first RF signal 261. The first RF signal 261 from the RF transceiver 220 may be amplified by the first power amplifier 260. The first RFFE module 230 may include a first control circuit 270 for controlling a switch within the first RFFE module 230 or for controlling a bias voltage of the first power amplifier 260. The first RFFE module 230 may include a first switching circuit 440 for the first control circuit 270. The first power supply circuit 250 may be configured to supply a first supply voltage 256 V_{cc1} to the first power amplifier 260 of the first RFFE module 230. The first power supply circuit 250 may generate the first supply voltage 256 based on a battery voltage 245 supplied from the battery 240. According to an embodiment, the RF transceiver 220 may control at least a part of the first RFFE module 230 through a control interface 223 (e.g., a mobile industry processor interface (MIPI)). According to an embodiment, the RF transceiver 220 may control at least a part of the first power supply circuit 250 through a control interface 225 (e.g., a MIPI).

The second RFFE module 630 may be configured to transmit a transmission signal (e.g., a second RF signal 661) from the RF transceiver 220 to the antenna 690. The second RFFE module 630 may include a second power amplifier 660 for a second RF signal 661. The second RF signal 661 from the RF transceiver 220 may be amplified by the second power amplifier 660. The second RFFE module 630 may include a second control circuit 670 for controlling a switch within the second RFFE module 630 or for controlling a bias voltage of the second power amplifier 660. The second RFFE module 630 may include a second switching circuit 640 for the second control circuit 670. The second power supply circuit 650 may be configured to supply a second supply voltage 656 V_{cc2} to the second power amplifier 660 of the second RFFE module 630. The second power supply circuit 650 may generate the second supply voltage 656 based on the battery voltage 245 supplied from the battery 240. According to an embodiment, the RF transceiver 220 may control at least a part of the second RFFE module 630 through a control interface 623 (e.g., a MIPI). According to an embodiment, the RF transceiver 220 may control at least a part of the second power supply circuit 650 through a control interface 625 (e.g., a MIPI).

The first power supply circuit 250 may generate the first supply voltage 256 to the first power amplifier 260 based on an APT method or an ET method for power efficiency. The second power supply circuit 650 may generate the second supply voltage 656 to the second power amplifier 660 based on the APT method or the ET method for power efficiency. APT is a technology supplying a fixed magnitude of voltage through a DC-DC converter. ET is a technology tracking an amplitude of an RF signal and supplying a voltage in a magnitude corresponding to an envelope. If a modulator supplying a voltage to a power amplifier in an RFFE module supplies the voltage to a control circuit in the RFFE module as in FIGS. 4A, 4B, and 4C, and FIGS. 5A, 5B, and 5C, a certain limitation is required on a magnitude of the supplied voltage. For example, since stable power supply is required to ensure a normal operation of the control circuit, the voltage should be generated with a magnitude higher than or equal to a voltage threshold. If the supply voltage (e.g., V_{cc}) applied to the power amplifier is too low, unstable performance may be caused in control of the RFFE module as the control circuit is difficult to operate normally. If a supply voltage applied to a power amplifier is too high, unnecessary power consumption may be caused at a saturation level. In order to solve the above-described problem, the electronic device 101 according to embodiments of the present disclosure may include an RFFE structure in which the first power supply circuit 250 is connected to an end (e.g., a second throw 642b) of the second switching circuit 640 of the second RFFE module 630, and the second power supply circuit 650 is connected to an end (e.g., a second throw 442b) of the first switching circuit 440 of the first RFFE module 230.

According to an embodiment, the first switching circuit 440 may be configured to selectively connect the battery 240 or an output of the second power supply circuit 650 to the first control circuit 270. According to an embodiment, if the battery voltage 245 is lower than a voltage threshold, the electronic device 101 (e.g., the processor 210) may control the first switching circuit 440 to supply the second supply voltage 656 of the second power supply circuit 650 to the first control circuit 270. If the battery voltage 245 is higher than or equal to the voltage threshold, the electronic device 101 (e.g., the processor 210) may control the first switching circuit 440 to supply the battery voltage 245 to the first control circuit 270. The battery voltage 245 of the battery 240 or the second supply voltage 656 of the second power supply circuit 650 may be supplied to the first control circuit 270 through the first switching circuit 440. As a non-limiting example, the first switching circuit 440 may be electrically connected to the first control circuit 270 through an inductor (e.g., an inductor 510). As an example, the first switching circuit 440 may include an SPDT. A pole 441 of the first switching circuit 440 may be electrically connected to a first throw 442a or a second throw 442b. The pole 441 may be electrically connected to the first control circuit 270 through a wiring 447. The first throw 442a may be electrically connected to the battery 240. For example, the first throw 442a may be electrically connected to the battery 240. While the first switching circuit 440 connects the first throw 442a and the pole 441, the battery voltage 245 may be supplied to the first control circuit 270. The second throw 442b may be electrically connected to the second power supply circuit 650. For example, the second throw 442b may be electrically connected to the second power supply circuit 650 through a second wiring 692. While the first switching circuit 440 connects the second throw 442b and the pole 441, the second supply voltage 656 may be supplied to the first control circuit 270 through the second wiring 692.

According to an embodiment, the second switching circuit 640 may be configured to selectively connect the battery 240 or an output of the first power supply circuit 250 to the second control circuit 670. According to an embodiment, if the battery voltage 245 is lower than a voltage threshold, the electronic device 101 (e.g., the processor 210) may control the second switching circuit 640 to supply the first supply voltage 256 of the first power supply circuit 250 to the second control circuit 670. If the battery voltage 245 is higher than or equal to the voltage threshold, the electronic device 101 (e.g., the processor 210) may control the second switching circuit 640 to supply the battery voltage 245 to the second control circuit 670. The battery voltage 245 of the battery 240 or the first supply voltage 256 of the first power supply circuit 250 may be supplied to the second control circuit 670 through the second switching circuit 640. As a non-limiting example, the second switching circuit 640 may be electrically connected to the second control circuit 670 through an inductor (e.g., the inductor 510). As an example, the second switching circuit 640 may include an SPDT. A pole 641 of the second switching circuit 640 may be electrically connected to a first throw 642a or a second throw 642b. The pole 641 may be electrically connected to the second control circuit 670 through a wiring 647. The first throw 642a may be electrically connected to the battery 240. While the second switching circuit 640 connects the first throw 642a and the pole 641, the battery voltage 245 may be supplied to the second control circuit 670. The second throw 642b may be electrically connected to the first power supply circuit 250. For example, the second throw 642b may be electrically connected to the first power supply circuit 250 through the first wiring 691. While the second switching circuit 640 connects the second throw 642b and the pole 641, the first supply voltage 256 may be supplied to the second control circuit 670 through the first wiring 691.

Through the RFFE structure (e.g., the first wiring 691 or the second wiring 692) exemplified in FIG. 6, a control circuit (e.g., the first control circuit 270) of an RFFE module (e.g., the first RFFE module 230) may operate normally, even if a supply voltage (e.g., the first supply voltage V_{cc1}) of a power amplifier (e.g., the first power amplifier 260) operating in the RFFE module (e.g., the first RFFE module 230) is not increased to a certain voltage (e.g., higher than or equal to a voltage threshold). A supply voltage (e.g., the second supply voltage V_{cc2}) may be stably applied to the control circuit (e.g., the second control circuit 670) through another power supply circuit (e.g., the second power supply circuit 650). In addition, since a power supply circuit (e.g., the first RFFE module 230) for the RFFE module (e.g., the first RFFE module 230) generates a supply voltage (e.g., the first supply voltage V_{cc1}) in an intended manner for a power amplifier (e.g., the first power amplifier 260), a gain of current consumption may be obtained from the RFFE module (e.g., the first RFFE module 230).

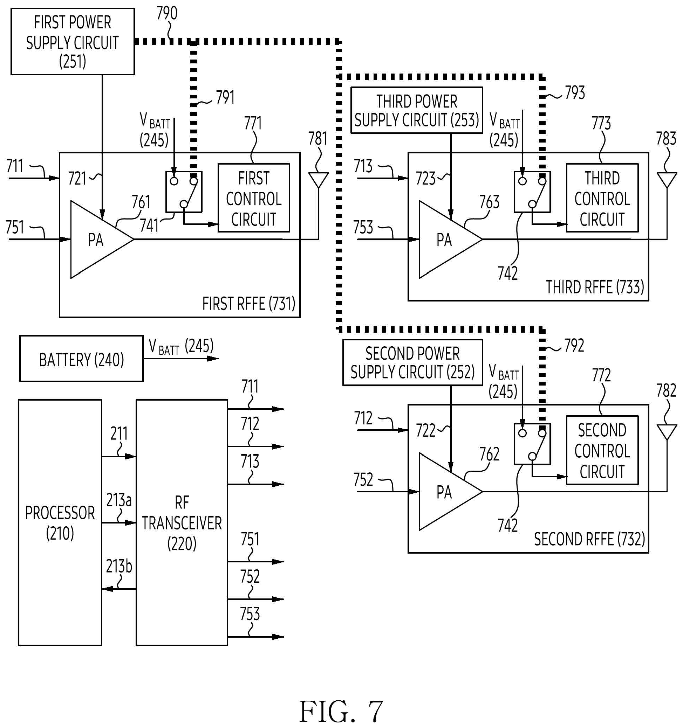

FIG. 7 represents an example of an electronic device (e.g., an electronic device 101) for supplying a supply voltage of a power amplifier (e.g., a power amplifier 260) to each RFFE module. For efficiency of a power supply, a RFFE structure in which a supply voltage of one power supply circuit is transmitted to control circuits of other RFFE modules is described in FIG. 7. The same reference numbers may be used for the same description.

Referring to FIG. 7, the electronic device 101 may include a processor 210, an RF transceiver 220, or a battery 240. In order to support various frequency combinations, the electronic device 101 may include a plurality of TX/RX modules (e.g., RFFE modules). For example, the electronic device 101 may include a first RFFE module 731, a second RFFE module 732, and a third RFFE module 733. The RF transceiver 220 may control each RFFE module through a control interface (e.g., a MIPI). For example, the RF transceiver 220 may control the first RFFE module 731 through a first control signal 711. The RF transceiver 220 may control the second RFFE module 732 through a second control signal 712. The RF transceiver 220 may control the third RFFE module 733 through a third control signal 713.

For each RFFE module of a plurality of RFFE modules, the descriptions of FIGS. 2 to 6 may be referenced. Each RFFE module may include a power amplifier configured to amplify an RF signal from the RF transceiver 220. For example, the first RFFE module 731 may include a first power amplifier 761 configured to amplify a first RF signal 751. The second RFFE module 731 may include a second power amplifier 762 configured to amplify a second RF signal 752. The third RFFE module 733 may include a third power amplifier 763 configured to amplify a third RF signal 753. Each RFFE module may be connected to an antenna. A signal amplified through a power amplifier of an RFFE module may be radiated to the outside through an antenna connected to the RFFE module. For example, a signal (e.g., the amplified first RF signal 751) amplified through the first power amplifier 761 may be radiated to an outside through a first antenna 781 connected to the first RFFE module 731. A signal (e.g., the amplified second RF signal 752) amplified through the second power amplifier 762 may be radiated to the outside through a second antenna 782 connected to the second RFFE module 732. A signal (e.g., the amplified third RF signal 753) amplified through the third power amplifier 763 may be radiated to the outside through a third antenna 783 connected to the third RFFE module 733. Each RFFE module may include a control circuit for controlling a logic circuit and/or a switch within the corresponding RFFE module or for controlling a bias voltage supplied to a power amplifier of the corresponding RFFE module. For example, the first RFFE module 731 may include a first control circuit 771. The second RFFE module 732 may include a second control circuit 772. The third RFFE module 733 may include a third control circuit 773. In order to adaptively change a power to be supplied to a control circuit, each RFFE module may include a switching circuit for the control circuit. For example, the first RFFE module 731 may include a first switching circuit 741 for the first control circuit 771. The second RFFE module 732 may include a second switching circuit 742 for the second control circuit 772. The third RFFE module 733 may include a third switching circuit 743 for the third control circuit 773.

For each TX module, the electronic device 101 may include a plurality of power supply circuits (e.g., a modulator). For example, the electronic device 101 may include a first power supply circuit 251 for the first RFFE module 731, a second power supply circuit 252 for the second RFFE module 732, and a third power supply circuit 253 for the third RFFE module 733. The first power supply circuit 251 may be configured to apply a first supply voltage 721 to the first power amplifier 761. The second power supply circuit 252 may be configured to apply a second supply voltage 722 to the second power amplifier 762. The third power supply circuit 253 may be configured to apply a third supply voltage 723 to the third power amplifier 763.

According to an embodiment, the first supply voltage 721 of the first power supply circuit 251 may be provided not only to the first switching circuit 741 of the first RFFE module 731, but also to the second switching circuit 742 of the second RFFE module 732 and the third switching circuit 743 of the third RFFE module 733. The electronic device 101 may provide the first supply voltage 721 to a switching circuit of each RFFE module through a wiring 790 from the first power supply circuit 251. For example, a first branch 791 of the wiring 790 may be connected to the first switching circuit 741. While the first control circuit 771 is connected to the first branch 791 through the first switching circuit 741, the first supply voltage 721 may be transmitted to the first control circuit 771 through the first branch 791. A second branch 792 of the wiring 790 may be connected to the second switching circuit 742. While the second control circuit 772 is connected to the second branch 792 through the second switching circuit 742, the first supply voltage 721 may be transmitted to the second control circuit 772 through the second branch 792. A third branch 793 of the wiring 790 may be connected to the third switching circuit 743. While the third control circuit 773 is connected to the third branch 793 through the third switching circuit 743, the first supply voltage 721 may be transmitted to the third control circuit 773 through the third branch 793.

According to an embodiment, the electronic device 101 (e.g., the processor 210) may control the first power supply circuit 251 such that the first supply voltage 721 is always higher than or equal to the voltage threshold while the first supply voltage 721 is provided to each control circuit. For example, the electronic device 101 may set all supply power values corresponding to a specific transmit power level in the first power supply circuit 251 to be higher than or equal to the voltage threshold through a value stored in memory (e.g., a non-volatile memory 134).

According to an embodiment, the first switching circuit 741 may be configured to selectively and electrically connect the battery 240 or the first power supply circuit 251 to the first control circuit 771. According to an embodiment, if the battery voltage 245 is lower than a voltage threshold, the electronic device 101 (e.g., the processor 210) may control the first switching circuit 741 to supply the first supply voltage 721 of the first power supply circuit 251 to the first control circuit 771. If the battery voltage 245 is higher than or equal to the voltage threshold, the electronic device 101 (e.g., the processor 210) may control the first switching circuit 741 to supply the battery voltage 245 to the first control circuit 771. According to an embodiment, the second switching circuit 742 may be configured to selectively and electrically connect the battery 240 or the first power supply circuit 251 to the second control circuit 772. According to an embodiment, if the battery voltage 245 is lower than a voltage threshold, the electronic device 101 (e.g., the processor 210) may control the second switching circuit 742 to supply the first supply voltage 721 of the first power supply circuit 251 to the second control circuit 772. If the battery voltage 245 is higher than or equal to the voltage threshold, the electronic device 101 (e.g., the processor 210) may control the second switching circuit 742 to supply the battery voltage 245 to the second control circuit 772. According to an embodiment, the third switching circuit 743 may be configured to selectively and electrically connect the battery 240 or the first power supply circuit 251 to the third control circuit 773. According to an embodiment, if the battery voltage 245 is lower than a voltage threshold, the electronic device 101 (e.g., the processor 210) may control the third switching circuit 743 to supply the first supply voltage 721 of the first power supply circuit 251 to the third control circuit 773. If the battery voltage 245 is higher than or equal to the voltage threshold, the electronic device 101 (e.g., the processor 210) may control the third switching circuit 743 to supply the battery voltage 245 to the third control circuit 773.

If the battery voltage 245 of the battery 240 is lower than a threshold, through the wiring 790 of FIG. 7, the first supply voltage 721 may be supplied to each control circuit through the first power supply circuit 251. While the first supply voltage 721 is provided to the second control circuit 772, the second power supply circuit 252 may supply the second supply voltage 722 to the second power amplifier 762 independently of the first power supply circuit 251. Since the processor 210 may freely control a supply voltage of the second power supply circuit 252, current consumption for the second power amplifier 762 of the second RFFE module 732 may be reduced. For example, while the first supply voltage 721 is provided to the third control circuit 773, the third power supply circuit 253 may supply the third supply voltage 723 to the third power amplifier 763 independently of the first power supply circuit 251. Since the processor 210 may freely control a supply voltage of the third power supply circuit 253, current consumption for the third power amplifier 763 of the third RFFE module 733 may be reduced.

In FIG. 7, it is illustrated that the first branch 791 of the wiring 790 is disposed outside the first RFFE module 731, but embodiments of the present disclosure are not limited thereto. In order to supply the first supply voltage 721 to the first switching circuit 741, a wiring that shares an output of the first power supply circuit 251 may be disposed within the first RFFE module 731.

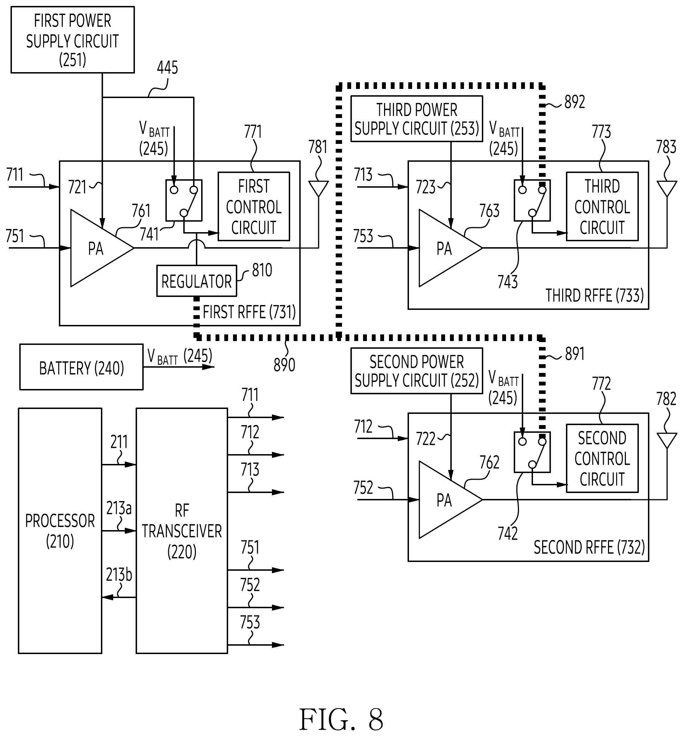

FIG. 8 represents an example of an electronic device (e.g., an electronic device 101) for supplying a supply voltage of a power amplifier (e.g., a power amplifier 260) to each RFFE module. For efficiency of a power supply, a RFFE structure in which a supply voltage of one power supply circuit (e.g., the first power supply circuit 251 of FIG. 7) is transmitted to control circuits (e.g., a second control circuit 772 and a third control circuit 773) of other RFFE modules is described in FIG. 8. The same reference numbers may be used for the same description.

Referring to FIG. 8, the electronic device 101 may include a processor 210, an RF transceiver 220, or a battery 240. In order to support various frequency combinations, the electronic device 101 may include a plurality of TX/RX modules (e.g., RFFE modules). For components of the electronic device 101 of FIG. 8, the descriptions of FIG. 7 may be referenced. In FIG. 7, an example in which a wiring (e.g., a wiring 790) from the first power supply circuit 251 is connected to a switching circuit of each RFFE module has been described. However, as a distance between RFFE modules increases, the wiring may be longer. As a non-limiting example, in a foldable type electronic device including a first housing and a second housing, a first RFFE module (e.g., a first RFFE module 731) may be disposed in the first housing and a second RFFE module (e.g., a second RFFE module 732) may be disposed in the second housing. The wiring lengthened due to a structural problem may cause parasitic resonance during an ET operation of the power supply circuit. In addition, as a length of the wiring increases, noise increases and signal transmission is delayed, and thus performance degradation of RFFE modules may occur. An RFFE structure that provides a supply voltage of the same power supply circuit to each switching circuit of RFFE modules, but may have a shorter wiring length than a wiring length exemplified in FIG. 7 is described in FIG. 8.

According to an embodiment, the first RFFE module 731 may include a regulator 810 (e.g., LDO (low dropout). A first switching circuit 741 may provide a first supply voltage 721 of the first power supply circuit 251 not only to the first switching circuit 741 of the first RFFE module 731, but also to a second switching circuit 742 of the second RFFE module 732 and a third switching circuit 743 of a third RFFE module 733. The first supply voltage 721 provided to a first control circuit 771 through the regulator 810 of the electronic device 101 may be provided to the second switching circuit 742 and the third switching circuit 743. The first switching circuit 741 may be connected to the regulator 810. For example, the regulator 810 may include at least one active element (e.g., a transistor). The regulator 810 may be configured to output a stable voltage even at a low input/output voltage. The regulator 810 may be configured to obtain a voltage supplied to the first control circuit 771 through the first switching circuit 741. For example, the regulator 810 may obtain the first supply voltage 721 or a battery voltage 245. The regulator 810 may output an output voltage based on the obtained voltage.

The regulator 810 may be connected to the second switching circuit 742 and the third switching circuit 743 through a wiring 890. The output voltage of the regulator 810 may be transmitted to the second switching circuit 742 or the third switching circuit 743 through the wiring 890. A first branch 891 of the wiring 890 may be connected to the second switching circuit 742. While the second control circuit 772 is connected to the first branch 891 through the second switching circuit 742, the first supply voltage 721 may be transmitted to the control circuit 742 through the first branch 891. Since a voltage threshold at which switching of the first switching circuit 741 is triggered and a voltage threshold at which switching of the second switching circuit 741 is triggered are the same, the first supply voltage 721 may be supplied to the second control circuit 772 while the first supply voltage 721 is supplied to the first control circuit 771. For example, a second branch 892 of the wiring 890 may be connected to the third switching circuit 743. While the third control circuit 773 is connected to the second branch 892 through the third switching circuit 743, the first supply voltage 721 may be transmitted to the third control circuit 773 through the second branch 892. Since the voltage threshold at which switching of the first switching circuit 741 is triggered and the voltage threshold at which switching of the third switching circuit 743 is triggered are the same, the first supply voltage 721 may be supplied to the third control circuit 773 while the first supply voltage 721 is supplied to the first control circuit 771.

According to an embodiment, the first switching circuit 741 may be configured to selectively connect the battery 240 or an output of the first power supply circuit 251 to the first control circuit 771. According to an embodiment, if the battery voltage 245 is lower than a voltage threshold, the electronic device 101 (e.g., the processor 210) may control the first switching circuit 741 to supply the first supply voltage 721 of the first power supply circuit 251 to the first control circuit 771. If the battery voltage 245 is higher than or equal to the voltage threshold, the electronic device 101 (e.g., the processor 210) may control the first switching circuit 741 to supply the battery voltage 245 to the first control circuit 771.

According to an embodiment, the second switching circuit 742 may be configured to selectively connect the battery 240 or the first branch 891 of the wiring 890 to the second control circuit 772. According to an embodiment, if the battery voltage 245 is lower than a voltage threshold, the electronic device 101 (e.g., the processor 210) may control the second switching circuit 742 to supply the first supply voltage 721 of the first power supply circuit 251 to the second control circuit 772. If the battery voltage 245 is higher than or equal to the voltage threshold, the electronic device 101 (e.g., the processor 210) may control the second switching circuit 742 to supply the battery voltage 245 to the second control circuit 772.

According to an embodiment, the third switching circuit 743 may be configured to selectively connect the battery 240 or the second branch 892 of the wiring 890 to the third control circuit 773. According to an embodiment, if the battery voltage 245 is lower than a voltage threshold, the electronic device 101 (e.g., the processor 210) may control the third switching circuit 743 to supply the first supply voltage 721 of the first power supply circuit 251 to the third control circuit 773. If the battery voltage 245 is higher than or equal to the voltage threshold, the electronic device 101 (e.g., the processor 210) may control the third switching circuit 743 to supply the battery voltage 245 to the third control circuit 773.

Since a length of a wiring directly connected to the first power supply circuit 251 is reduced through the RFFE structure (e.g., the wiring 890) exemplified in FIG. 8, excellent communication performance may be provided during an ET operation compared to the RFFE structure exemplified in FIG. 7.

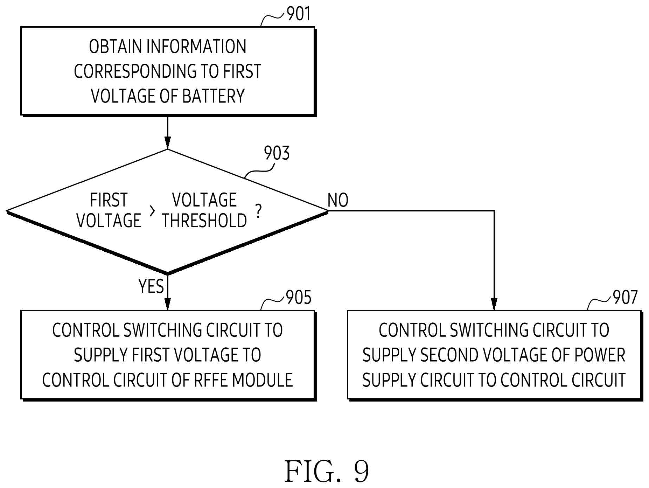

FIG. 9 represents an operation flow of an electronic device (e.g., an electronic device 101) for supplying a voltage to a control circuit (e.g., a control circuit 270) of an RFFE module (e.g., an RFFE module 230).

Referring to FIG. 9, in an operation 901, an electronic device 101 (e.g., a processor 210) may obtain information corresponding to a first voltage (e.g., a battery voltage 245) of a battery (e.g., a battery 240). For example, the electronic device 101 may monitor a battery voltage 245 of the battery 240.

In an operation 903, the electronic device 101 (e.g., the processor 210) may identify whether the first voltage is greater than a voltage threshold. The first voltage may indicate the battery voltage 245. Since use of the battery 240 causes a decrease in the battery voltage 245, a control circuit 270 may be difficult to operate normally if the battery voltage 245 is lowered less than or equal to a certain threshold (hereinafter, a voltage threshold) (e.g., approximately 3.4V or approximately 3.2V). The voltage threshold may be set to be higher than or equal to a voltage guaranteed for components of an RFFE module (e.g., the RFFE module 230) of the electronic device 101 to perform a normal operation. For example, the voltage threshold may be set to be higher than or equal to a voltage value (e.g., 3.2V) for a normal operation of a PA bias circuit 310 of the control circuit 270. For example, the voltage threshold may be set to be higher than or equal to a voltage value required for a switch, a switching module, and/or a logic circuit within the RFFE module 230 to operate normally.

The electronic device 101 may perform an operation 905 in a case that the first voltage is greater than the voltage threshold. The electronic device 101 may perform an operation 907 in a case that the first voltage is not greater than the voltage threshold.

In the operation 905, the electronic device 101 (e.g., the processor 210) may control a switching circuit (e.g., a switching circuit 440) to supply the first voltage to a control circuit (e.g., the control circuit 270) of the RFFE module (e.g., the RFFE module 230). Since the RFFE module may perform a normal operation through the battery voltage 245 of the battery 240, the electronic device 101 may control the switching circuit 440 such that the battery voltage 245 is supplied to the control circuit 270. According to an embodiment, if the first voltage is greater than the voltage threshold while the switching circuit 440 is connected to the power supply circuit 250, the processor 210 may transmit a control signal for switching of the switching circuit 440 by controlling an RF transceiver 220. The switching circuit 440 may connect the control circuit 270 to the battery 240 based on the control signal.

In the operation 907, the electronic device 101 (e.g., the processor 210) may control the switching circuit (e.g., the switching circuit 440) to supply a second voltage of a power supply circuit to the control circuit (e.g., the control circuit 270). According to an embodiment, in a case that the first voltage is less than or equal to the voltage threshold while the switching circuit 440 is connected to the battery 240, the processor 210 may transmit a control signal for switching the switching circuit 440 by controlling the RF transceiver 220. The switching circuit 440 may connect the control circuit 270 to the power supply circuit 250 based on the control signal.

According to an embodiment, the power supply circuit may be configured to provide a supply voltage to a power amplifier (e.g., a power amplifier 260) of the RFFE module. According to another embodiment, the power supply circuit may be configured to provide the supply voltage to another power amplifier of another RFFE module other than the power amplifier (e.g., the power amplifier 260) of the RFFE module. Even if the first voltage becomes lower than the voltage threshold, the electronic device 101 may not be turned off. The electronic device 101 may normally drive the RFFE module through a supply voltage V_{cc} applied to the power amplifier while maintaining a turn-on state.

According to an embodiment, the electronic device 101 (e.g., the processor 210) may change a voltage value to be supplied to the power amplifier (e.g., the power amplifier 260) of the RFFE module (e.g., the RFFE module 230). The electronic device 101 may change the voltage value to be supplied to the power amplifier 260 of the RFFE module 230 based on a connection state of the switching circuit 440. For example, the electronic device 101 may set all supply power values corresponding to a specific transmit power level to be higher than or equal to the voltage threshold through a value stored in memory (e.g., a non-volatile memory 134). While the switching circuit 440 is connected to the battery 240, at least a part of voltage values (e.g., the first supply voltage values in Table 1) to be supplied to the power amplifier 260 may be lower than the voltage threshold (e.g., 3.2V). While the switching circuit 440 is connected to the power supply circuit 250, voltage values (e.g., the second supply voltage values in Table 1) to be supplied to the power amplifier 260 may all be higher than or equal to the voltage threshold.

**[TABLE 1]**

| Transmission power | First supply voltage values | Second supply voltage values |
|---|---|---|
| 17dBm | 3.5V | 3.5V |
| 16dBm | 3.1V | 3.2V |
| 15dBm | 2.9V | 3.2V |

The electronic device 101 may change the supply voltage values to be operated for the power amplifier 260 based on a connection state of the switching circuit 440. For example, in a case that the battery voltage 245 is lower than the voltage threshold, the electronic device 101 may change the first supply voltage values to the second supply voltage values with respect to the power supply circuit connected to the switching circuit 440. If a power supply circuit (e.g., a second power supply circuit 650) supplied to the switching circuit 440 is not supplying a power to the power amplifier 260 of the RFFE module 230 of the switching circuit 440, the electronic device 101 may not change supply voltage values with respect to another power supply circuit (e.g., the first power supply circuit 250). For example, the electronic device 101 may maintain the first supply voltage values with respect to the first power supply circuit 250 and the first power amplifier 260.

A communication module (e.g., the RFFE module 230) according to embodiments of the present disclosure may selectively supply the first voltage (e.g., the battery voltage 245) of the battery (e.g., the battery 240) and the second voltage (e.g., the supply voltage 256) supplied to the power amplifier (e.g., the power amplifier 260) to the control circuit through the switching circuit (e.g., the switching circuit 440) connected to the control circuit (e.g., the control circuit 270). By adaptively providing the first voltage and the second voltage to the control circuit based on a magnitude of the first voltage, the communication module may be enabled to stably support transmission and reception without performance degradation of the communication module even at a low power. Accordingly, the electronic device (e.g., the electronic device 101) may continue to be connected to a network even at the low power. The effects that may be obtained from the present disclosure are not limited to those described above, and any other effects not mentioned herein will be clearly understood by those having ordinary knowledge in the art to which the present disclosure belongs, from the following description.

In embodiments, an electronic device 101 is provided. The electronic device 101 may comprise a processor 210, a radio frequency (RF) transceiver 220, a radio frequency end (RFFE) module connected to the RF transceiver 220, an antenna connected to the RFFE module, a battery configured to provide a first voltage 245, and a power supply circuit configured to supply a second voltage 256, 656, or 721 for a power amplifier (PA) based on the first voltage 245. The RFFE module may include a control circuit for controlling a PA bias within the RFFE module and at least one switch within the RFFE module and a switching circuit for the control circuit. The processor 210 may be configured to control the switching circuit to supply, to the control circuit, the first voltage 245 between the first voltage 245 and the second voltage 256, 656, or 721 based on the first voltage 245 being higher than or equal to a voltage threshold. The processor 210 may be configured to control the switching circuit to supply, to the control circuit, the second voltage 256, 656, or 721 between the first voltage 245 and the second voltage 256, 656, or 721 based on the first voltage 245 being lower than the voltage threshold.

In embodiments, an electronic device 101 is provided. The electronic device 101 may comprise a processor 210, a radio frequency (RF) transceiver 220, a radio frequency end (RFFE) module connected to the RF transceiver 220, an antenna connected to the RFFE module, a battery configured to provide a first voltage 245, and a power supply circuit configured to supply a second voltage 256, 656, or 721 for a power amplifier (PA) based on the first voltage 245. The RFFE module may include a control circuit for controlling a PA bias within the RFFE module and at least one switch within the RFFE module and a switching circuit for the control circuit. The switching circuit may be controlled, in accordance with control of the processor 210 or the RF transceiver 220, to supply, to the control circuit, the first voltage 245 between the first voltage 245 and the second voltage 256, 656, or 721 based on the first voltage 245 being higher than or equal to a voltage threshold. The switching circuit may be controlled, in accordance with control of the processor 210 or the RF transceiver 220, supply, to the control circuit, the second voltage 256, 656, or 721 between the first voltage 245 and the second voltage 256, 656, or 721 based on the first voltage 245 being lower than the voltage threshold.

According to an embodiment, the control circuit may include at least one of a PA bias circuit for supplying a bias voltage for a PA of the RFFE module, a logic circuit for controlling the at least one switch, or a supply circuit for supplying a power to the at least one switch. The voltage threshold may be set to be equal to or greater than a voltage value for operations of components of the control circuit.

According to an embodiment, the switching circuit may be configured to connect the control circuit to a first output of the battery or a second output of the power supply circuit selectively. The switching circuit may be electrically connected to the control circuit through an inductor 510 disposed outside the RFFE module.

According to an embodiment, the electronic device 101 may comprise a second power supply circuit different from the power supply circuit, a second RFFE module, different from the RFFE module, including the PA, and a second antenna connected to the second RFFE module. The RFFE module may include a second PA to which a third voltage different from the second voltage 256, 656, or 721 is applied from the second power supply circuit. The second RFFE may module includes a second control circuit for controlling a PA bias within the second RFFE module and at least one switch within the second RFFE module and a second switching circuit for the second control circuit.

According to an embodiment, the electronic device 101 may comprise a first wiring for electrically connecting the power supply circuit and each of the RFFE module and the second RFFE module, and a second wiring for electrically connecting the second power supply circuit and each of the RFFE module and the second RFFE module.

The first wiring may include a first branch corresponding to the switching circuit of the RFFE module from the power supply circuit and a second branch corresponding to the PA of the second RFFE module from the power supply circuit. The second wiring may include a third branch corresponding to the second PA of the RFFE module from the second power supply circuit and a fourth branch corresponding to the PA of the second RFFE module from the second power supply circuit.

According to an embodiment, the switching circuit may be configured to supply, to the control circuit, one of the first voltage 245 of the battery and the second voltage 256, 656, or 721 of the power supply circuit. The second switching circuit may be configured to supply, to the second control circuit, one of the first voltage 245 of the battery and the third voltage of the second power supply circuit.

According to an embodiment, a third voltage may be supplied to the second PA of the RFFE module through the second power supply circuit. In a case that the first voltage 245 is lower than the voltage threshold while the third voltage is supplied to the second PA of the RFFE module through the second power supply circuit, the second voltage 256, 656, or 721 may be supplied to the switching circuit of the RFFE module through the power supply circuit. The second power supply circuit may be configured to provide the third voltage with a fixed magnitude based on average power tracking (APT) or a variable magnitude based on envelope tracking (ET).

According to an embodiment, the processor 210 may be configured to obtain information corresponding to the first voltage 245, identify whether the first voltage 245 is lower than the voltage threshold or not, and transmit, to the RFFE module, a control signal for changing the switching circuit to supply the second voltage 256, 656, or 721 to the control circuit in a case that the first voltage 245 is lower than the voltage threshold while the first voltage 245 is being supplied to the control circuit.

According to an embodiment, the processor 210 may be configured to transmit, to the RFFE module, a control signal for changing the switching circuit to supply the second voltage 256, 656, or 721 to the control circuit in a case that the first voltage 245 is higher than or equal to the voltage threshold while the second voltage 256, 656, or 721 is being supplied to the control circuit.

According to an embodiment, the RFFE module may include the PA to which the second voltage 256, 656, or 721 is applied from the power supply circuit. The switching circuit may be configured to selectively connect the control circuit to the battery or the power supply circuit.

According to an embodiment, the electronic device 101 may comprise a second power supply circuit different from the power supply circuit, a second RFFE module, different from the RFFE module, including a second PA, and a second antenna connected to the second RFFE module. The second RFFE module may include a second control circuit for controlling a PA bias within the second RFFE module and at least one switch within the second RFFE module and a second switching circuit for the second control circuit. The second PA may operate based on a third voltage from the second power supply circuit. The switching circuit may be configured to supply, to the control circuit, one of the first voltage 245 of the battery and the second voltage 256, 656, or 721 of the power supply circuit. The second switching circuit may be configured to supply, to the second control circuit, one of the first voltage 245 of the battery and the second voltage 256, 656, or 721 of the power supply circuit. According to an embodiment, a wiring for electrically connecting the power supply circuit to the RFFE module and the second RFFE module may be included. The wiring may include a first branch for the PA of the RFFE module, a second branch for the switching circuit of the RFFE module, and a third branch for the second switching circuit of the second RFFE module.

According to an embodiment, a second power supply circuit different from the power supply circuit, a second RFFE module, different from the RFFE module, including a second PA, and a second antenna connected to the second RFFE module may be included. The second RFFE module may include a second control circuit for controlling a PA bias within the second RFFE module and at least one switch within the second RFFE module and a second switching circuit for the second control circuit. The RFFE module may include a regulator. The regulator may be configured to provide, to the second RFFE module, a voltage supplied to the control circuit. The switching circuit may be configured to supply, to the control circuit, one of the first voltage 245 of the battery and the second voltage of the power supply circuit. The second switching circuit may be configured to supply, to the second control circuit, one of the first voltage 245 of the battery and the second voltage obtained through the regulator.

According to an embodiment, a wiring for electrically connecting a regulator of the RFFE module and the second RFFE module may be included. The wiring may be used to provide a voltage supplied to the control circuit to the second control circuit of the second RFFE module.

According to an embodiment, while the second voltage 256, 656, or 721 of the power supply circuit is supplied to the control circuit through the switching circuit, the power supply circuit may be configured to provide the second voltage 256, 656, or 721 with a fixed magnitude based on average power tracking (APT).

According to an embodiment, the electronic device 101 may comprise a non-volatile memory. The non-volatile memory may comprise first supply voltage values for a first state in which the first voltage 245 of the battery is supplied to the control circuit through the switching circuit, and second supply voltage values for a second state in which the second voltage 256, 656, or 721 of the battery is supplied to the control circuit through the switching circuit. The processor 210 may be configured to control the power supply circuit to operate the PA with a first voltage value 245 corresponding to a power of a transmission signal among the first supply voltage values in the first state. The processor 210 may be configured to control the power supply circuit to operate the PA with a second voltage value 256, 656, or 721 corresponding to a power of a transmission signal among the second supply voltage values in the second state. At least a part of the first supply voltage values may be lower than the voltage threshold. All of the second supply voltage values may be above the voltage threshold.

In embodiments, a radio frequency end (RFFE) module is provided. The RFFE module may comprise a power amplifier (PA), a control circuit for controlling a PA bias to the PA and at least one switch within the RFFE module, and a switching circuit for the control circuit. The RFFE module may be configured to obtain a first voltage 245 of a battery and obtain a second voltage 256, 656, or 721 of a power supply circuit. The switching circuit may be configured to selectively supply the first voltage 245 of the battery or the second voltage 256, 656, or 721 of the power supply circuit to the control circuit. The control circuit may include at least one of a PA bias circuit for supplying a bias voltage for the PA, a logic circuit for controlling the at least one switch, or a supply circuit for supplying a power to the at least one switch.

According to an embodiment, the switching circuit may be electrically connected to the control circuit through an inductor 510 disposed outside the RFFE module.

According to an embodiment, the power amplifier may be configured to operate based on the second voltage 256, 656, 721 obtained through the power supply circuit or operate based on a third voltage obtained through a second power supply circuit different from the power supply circuit.

According to an embodiment, the RFFE module may include a bias path for providing the second voltage 256, 656, or 721 to the power amplifier and a wiring for connecting the bias path to the switching circuit.

A processor 120 or 210 of the present closure may include various processing circuits and/or multiple processors. For example, a term "processor" used in this document, including claims, may include various processing circuits including at least one processor, and one or more of the at least one processor may be configured to perform the various function(s) described in the present disclosure individually and/or collectively. As used in the present disclosure, in a case that "a processor", "at least one processor", and "one or more processors" are described as being configured to perform various functions, these terms may include, for example, situations in which one processor performs without limitation, situations in which other processor(s) perform a part of the cited functions and other functions among the cited functions and a single processor may perform all of the cited functions, and/or a combination of processors performed in a distributed manner. In addition, instructions (or program commands) for various function(s) in the present disclosure may cause an electronic device (e.g., the electronic device 101) to execute the various function(s) when executed by the processor.

The electronic device according to various embodiments may be one of various types of electronic devices. The electronic devices may include, for example, a portable communication device (e.g., a smartphone), a computer device, a portable multimedia device, a portable medical device, a camera, a wearable device, or a home appliance. According to an embodiment of the disclosure, the electronic devices are not limited to those described above.

It should be appreciated that various embodiments of the present disclosure and the terms used therein are not intended to limit the technological features set forth herein to particular embodiments and include various changes, equivalents, or replacements for a corresponding embodiment. With regard to the description of the drawings, similar reference numerals may be used to refer to similar or related elements. It is to be understood that a singular form of a noun corresponding to an item may include one or more of the things unless the relevant context clearly indicates otherwise. As used herein, each of such phrases as "A or B," "at least one of A and B," "at least one of A or B," "A, B, or C," "at least one of A, B, and C," and "at least one of A, B, or C," may include any one of or all possible combinations of the items enumerated together in a corresponding one of the phrases. As used herein, such terms as "1st" and "2nd," or "first" and "second" may be used to simply distinguish a corresponding component from another, and does not limit the components in other aspect (e.g., importance or order). It is to be understood that if an element (e.g., a first element) is referred to, with or without the term "operatively" or "communicatively", as "coupled with," or "connected with" another element (e.g., a second element), it means that the element may be coupled with the other element directly (e.g., wiredly), wirelessly, or via a third element.

As used in connection with various embodiments of the disclosure, the term "module" may include a unit implemented in hardware, software, or firmware, and may interchangeably be used with other terms, for example, "logic," "logic block," "part," or "circuitry". A module may be a single integral component, or a minimum unit or part thereof, adapted to perform one or more functions. For example, according to an embodiment, the module may be implemented in a form of an application-specific integrated circuit (ASIC).

Various embodiments as set forth herein may be implemented as software (e.g., the program 140) including one or more instructions that are stored in a storage medium (e.g., internal memory 136 or external memory 138) that is readable by a machine (e.g., the electronic device 101). For example, a processor (e.g., the processor 120) of the machine (e.g., the electronic device 101) may invoke at least one of the one or more instructions stored in the storage medium, and execute it, with or without using one or more other components under the control of the processor. This allows the machine to be operated to perform at least one function according to the at least one instruction invoked. The one or more instructions may include a code generated by a compiler or a code executable by an interpreter. The machine-readable storage medium may be provided in the form of a non-transitory storage medium. Wherein, the term "non-transitory" simply means that the storage medium is a tangible device, and does not include a signal (e.g., an electromagnetic wave), but this term does not differentiate between a case in which data is semi-permanently stored in the storage medium and a case in which the data is temporarily stored in the storage medium.

According to an embodiment, a method according to various embodiments of the disclosure may be included and provided in a computer program product. The computer program product may be traded as a product between a seller and a buyer. The computer program product may be distributed in the form of a machine-readable storage medium (e.g., compact disc read only memory (CD-ROM)), or be distributed (e.g., downloaded or uploaded) online via an application store (e.g., PlayStore^{™}), or between two user devices (e.g., smart phones) directly. If distributed online, at least part of the computer program product may be temporarily generated or at least temporarily stored in the machine-readable storage medium, such as memory of the manufacturer's server, a server of the application store, or a relay server.

According to various embodiments, each component (e.g., a module or a program) of the above-described components may include a single entity or multiple entities, and some of the multiple entities may be separately disposed in different components. According to various embodiments, one or more of the above-described components may be omitted, or one or more other components may be added. Alternatively or additionally, a plurality of components (e.g., modules or programs) may be integrated into a single component. In such a case, according to various embodiments, the integrated component may still perform one or more functions of each of the plurality of components in the same or similar manner as they are performed by a corresponding one of the plurality of components before the integration. According to various embodiments, operations performed by the module, the program, or another component may be carried out sequentially, in parallel, repeatedly, or heuristically, or one or more of the operations may be executed in a different order or omitted, or one or more other operations may be added.

## Claims

1. An electronic device, comprising:
a processor;
a radio frequency (RF) transceiver;
a radio frequency front end (RFFE) module connected to the RF transceiver;
an antenna connected to the RFFE module;
a battery configured to provide a first voltage; and
a power supply circuit configured to supply a second voltage for a power amplifier (PA) based on the first voltage,
wherein the RFFE module includes a control circuit for controlling a PA bias within the RFFE module and at least one switch within the RFFE module and a switching circuit for the control circuit,
wherein the switching circuit is controlled, in accordance with control of the processor or the RF transceiver, to:
supply, to the control circuit, the first voltage between the first voltage and the second voltage based on the first voltage being higher than or equal to a voltage threshold, and
supply, to the control circuit, the second voltage between the first voltage and the second voltage based on the first voltage being lower than the voltage threshold.

2. The electronic device of claim 1,
wherein the control circuit includes at least one of a PA bias circuit for supplying a bias voltage for a PA of the RFFE module, a logic circuit for controlling the at least one switch, or a supply circuit for supplying a power to the at least one switch, and
wherein the voltage threshold is set to be equal to or greater than a voltage value for operations of components of the control circuit.

3. The electronic device of claim 1,
wherein the switching circuit is configured to connect the control circuit to a first output of the battery or a second output of the power supply circuit selectively, and
wherein the switching circuit is electrically connected to the control circuit through an inductor disposed outside the RFFE module.

4. The electronic device of claim 1, further comprising:
a second power supply circuit different from the power supply circuit;
a second RFFE module, different from the RFFE module, including the PA; and
a second antenna connected to the second RFFE module,
wherein the RFFE module includes a second PA to which a third voltage different from the second voltage is applied from the second power supply circuit, and
wherein the second RFFE module includes a second control circuit for controlling a PA bias within the second RFFE module and at least one switch within the second RFFE module and a second switching circuit for the second control circuit.

5. The electronic device of claim 4, further comprising:
a first wiring for electrically connecting the power supply circuit and each of the RFFE module and the second RFFE module; and
a second wiring for electrically connecting the second power supply circuit and each of the RFFE module and the second RFFE module,
wherein the first wiring includes a first branch corresponding to the switching circuit of the RFFE module from the power supply circuit and a second branch corresponding to the PA of the second RFFE module from the power supply circuit, and
wherein the second wiring includes a third branch corresponding to the second PA of the RFFE module from the second power supply circuit and a fourth branch corresponding to the PA of the second RFFE module from the second power supply circuit.

6. The electronic device of claim 4,
wherein the switching circuit is configured to supply, to the control circuit, one of the first voltage of the battery and the second voltage of the power supply circuit, and
wherein the second switching circuit is configured to supply, to the second control circuit, one of the first voltage of the battery and the third voltage of the second power supply circuit.

7. The electronic device of claim 4,
wherein a third voltage is supplied to the second PA of the RFFE module through the second power supply circuit,
wherein, in a case that the first voltage is lower than the voltage threshold while the third voltage is supplied to the second PA of the RFFE module through the second power supply circuit, the second voltage is supplied to the switching circuit of the RFFE module through the power supply circuit, and
wherein the second power supply circuit is configured to provide the third voltage with a fixed magnitude based on average power tracking (APT) or a variable magnitude based on envelope tracking (ET).

8. The electronic device of claim 1, wherein the processor is configured to:
obtain information corresponding to the first voltage,
identify whether the first voltage is lower than the voltage threshold or not, and
transmit, to the RFFE module, a control signal for changing the switching circuit to supply the second voltage to the control circuit in a case that the first voltage is lower than the voltage threshold while the first voltage is being supplied to the control circuit.

9. The electronic device of claim 8, wherein the processor is further configured to:
transmit, to the RFFE module, a control signal for changing the switching circuit to supply the second voltage to the control circuit in a case that the first voltage is higher than or equal to the voltage threshold while the second voltage is being supplied to the control circuit.

10. The electronic device of claim 1
wherein the RFFE module includes the PA to which the second voltage is applied from the power supply circuit, and
wherein the switching circuit is configured to selectively connect the control circuit to the battery or the power supply circuit.

11. The electronic device of claim 10, comprising:
a second power supply circuit different from the power supply circuit;
a second RFFE module, different from the RFFE module, including a second PA; and
a second antenna connected to the second RFFE module,
wherein the second RFFE module includes a second control circuit for controlling a PA bias within the second RFFE module and at least one switch within the second RFFE module and a second switching circuit for the second control circuit,
wherein the second PA operates based on a third voltage from the second power supply circuit,
wherein the switching circuit is configured to supply, to the control circuit, one of the first voltage of the battery and the second voltage of the power supply circuit, and
wherein the second switching circuit is configured to supply, to the second control circuit, one of the first voltage of the battery and the second voltage of the power supply circuit.

12. The electronic device of claim 11, comprising:
a wiring for electrically connecting the power supply circuit to the RFFE module and the second RFFE module,
wherein the wiring includes a first branch for the PA of the RFFE module, a second branch for the switching circuit of the RFFE module, and a third branch for the second switching circuit of the second RFFE module.

13. The electronic device of claim 10,
a second power supply circuit different from the power supply circuit;
a second RFFE module, different from the RFFE module, including a second PA; and
a second antenna connected to the second RFFE module,
wherein the second RFFE module includes a second control circuit for controlling a PA bias within the second RFFE module and at least one switch within the second RFFE module and a second switching circuit for the second control circuit,
wherein the RFFE module further includes a regulator,
wherein the regulator is configured to provide, to the second RFFE module, a voltage supplied to the control circuit,
wherein the switching circuit is configured to supply, to the control circuit, one of the first voltage of the battery and the second voltage of the power supply circuit, and
wherein the second switching circuit is configured to supply, to the second control circuit, one of the first voltage of the battery and the second voltage obtained through the regulator.

14. The electronic device of claim 1, further comprising:
a non-volatile memory,
wherein the non-volatile memory comprises;
first supply voltage values for a first state in which the first voltage of the battery is supplied to the control circuit through the switching circuit, and
second supply voltage values for a second state in which the second voltage of the battery is supplied to the control circuit through the switching circuit,
wherein the processor is configured to:
control the power supply circuit to operate the PA with a first voltage value corresponding to a power of a transmission signal among the first supply voltage values in the first state, and
control the power supply circuit to operate the PA with a second voltage value corresponding to a power of a transmission signal among the second supply voltage values in the second state,
wherein at least a part of the first supply voltage values are lower than the voltage threshold, and
wherein all of the second supply voltage values are above the voltage threshold.

15. A radio frequency front end (RFFE) module, comprising:
a power amplifier (PA);
a control circuit for controlling a PA bias to the PA and at least one switch within the RFFE module; and
a switching circuit for the control circuit,
wherein the RFFE module is configured to obtain a first voltage of a battery and obtain a second voltage of a power supply circuit,
wherein the switching circuit is configured to selectively supply the first voltage of the battery or the second voltage of the power supply circuit to the control circuit, and
wherein the control circuit includes at least one of a PA bias circuit for supplying a bias voltage for the PA, a logic circuit for controlling the at least one switch, or a supply circuit for supplying a power to the at least one switch.
